# EUROPEAN PATENT APPLICATION

(11) **EP 4 468 357 A1**
(43) Date of publication of application: **27.11.2024**
(21) Application number: 24165128.0
(22) Date of filing: 21.03.2024
(51) Int. Cl.: H01L 27/12, H01L 29/786

(54) **DISPLAY DEVICE AND METHOD FOR MANUFACTURING THE SAME**

(30) Priority: 24.04.2023 KR 20230053620
(71) Applicant: Samsung Display Co., Ltd., Yongin-si, Gyeonggi-do 17113 (KR)
(72) Inventor: SHIN, Hyeon Woo, Giheung-gu, Yongin-si, Gyeonggi-do (KR); CHOI, June Whan, Giheung-gu, Yongin-si, Gyeonggi-do (KR)
(74) Representative: Dr. Weitzel & Partner

(57) **Abstract**

A display device includes a pixel including a first transistor, and a driving circuit including a second transistor. The first transistor includes a first active layer including first source and drain regions apart from each other with a first channel region therebetween, a first gate insulating layer on the first active layer and covering the first channel, source and drain regions, and a first gate electrode on the first gate insulating layer and overlapping the first channel region. The second transistor includes a second active layer including second source and drain regions apart from each other with a second channel region therebetween, a second gate insulating layer on a part of the second active layer including the second channel region and exposing the second source and drain regions, and a second gate electrode disposed on the second gate insulating layer and overlapping the second channel region.

## Description

### BACKGROUND

### 1. Field

The invention relates to a display device and a method for manufacturing the display device.

### 2. Description of the Related Art

The importance of display devices has steadily increased with the development of multimedia technology. Accordingly, various types of display device such as a liquid crystal display device, an organic light emitting display device or the like have been widely used in various fields.

### SUMMARY

The invention is defined by the independent claims. Embodiments of the invention provide a display device including transistors having different structures and a method for manufacturing the display device.

However, features of the invention are not restricted to those set forth herein. The above and other features of embodiments of the invention will become more apparent to one of ordinary skill in the art to which the invention pertains by referencing the detailed description of the invention given below.

According to the invention, a display device includes a pixel including a first transistor located in a display area, and a driving circuit including a second transistor located in a non-display area, where the first transistor includes a first active layer including a first channel region, and a first source region and a first drain region which are spaced apart from each other with the first channel region interposed therebetween, a first gate insulating layer disposed on the first active layer and covering the first channel region, the first source region, and the first drain region, and a first gate electrode disposed on the first gate insulating layer and overlapping the first channel region, where the second transistor includes a second active layer including a second channel region, and a second source region and a second drain region which are spaced apart from each other with the second channel region interposed therebetween, a second gate insulating layer disposed on a part of the second active layer including the second channel region and exposing the second source region and the second drain region, and a second gate electrode disposed on the second gate insulating layer and overlapping the second channel region.

In an embodiment, overlapping the first channel region or the second channel region may mean, that the first gate electrode may have a length greater or smaller than the first channel region, and/or that the second gate electrode have a length greater or smaller than the second channel region. According to another embodiment, overlapping may mean that the first gate electrode may have the same length than the first channel region, and/or that the second gate electrode may have the same length than the second channel region.

In an embodiment, the first active layer and the second active layer may include a same oxide semiconductor.

In an embodiment, the first active layer and the second active layer may be disposed in a same layer as each other.

In an embodiment, the second gate electrode may overlap a part of the second source region and a part of the second drain region.

In an embodiment, the second gate insulating layer may expose a remaining part of the second source region and a remaining part of the second drain region except for the part of the second source region overlapping the second gate electrode and the part of the second drain region overlapping the second gate electrode.

In an embodiment, the first gate electrode may not overlap the first source region and the first drain region.

In an embodiment, the first gate electrode may overlap a part of the first source region and a part of the first drain region.

In an embodiment, the first gate electrode may overlap the first source region and the first drain region by a part having a first length in a longitudinal direction of the first channel region, the second gate electrode may overlap the second source region and the second drain region by a part having a second length in a longitudinal direction of the second channel region, and the second length may be greater than the first length.

In an embodiment, the first gate electrode may overlap the first source region and the first drain region by a part corresponding to a first ratio among parts overlapping the first active layer, the second gate electrode may overlap the second source region and the second drain region by a part corresponding to a second ratio among parts overlapping the second active layer, and the second ratio may be greater than the first ratio.

In an embodiment, the first transistor and the second transistor may be N-type oxide transistors, and an electron mobility of the second transistor may be higher than an electron mobility of the first transistor.

In an embodiment, the pixel may further include a third transistor. The third transistor may include a third active layer including a third channel region, and a third source region and a third drain region which are spaced apart from each other with the third channel region interposed therebetween, a third gate insulating layer disposed on a part of the third active layer including the third channel region and exposing the third source region and the third drain region, and a third gate electrode disposed on the third gate insulating layer and overlapping the third channel region.

In an embodiment, the driving circuit may further include a fourth transistor. The fourth transistor may include a fourth active layer including a fourth channel region, and a fourth source region and a fourth drain region which are spaced apart from each other with the fourth channel region interposed therebetween, a fourth gate insulating layer disposed on the fourth active layer and covering the fourth channel region, the fourth source region, and the fourth drain region, and a fourth gate electrode disposed on the fourth gate insulating layer and overlapping the fourth channel region.

According to the invention, a display device includes a pixel including a first transistor located in a display area, and a driving circuit including a second transistor located in a non-display area. In such an embodiment, the first transistor includes a first active layer including a first channel region, and a first source region and a first drain region which are spaced apart from each other with the first channel region interposed therebetween, a first gate insulating layer disposed on the first active layer, and a first gate electrode disposed on the first gate insulating layer and overlapping the first channel region. In such an embodiment, the second transistor includes a second active layer including a second channel region, and a second source region and a second drain region which are spaced apart from each other with the second channel region interposed therebetween, a second gate insulating layer disposed on the second active layer, and a second gate electrode disposed on the second gate insulating layer and may overlap a part of the second source region, a part of the second drain region, and the second channel region. In such an embodiment, the first gate electrode may not overlap the first source region and the first drain region, or may overlap the first source region and the first drain region by a part having a first length in a longitudinal direction of the first channel region, the second gate electrode may overlap the second source region and the second drain region by a part having a second length in a longitudinal direction of the second channel region, and the second length may be greater than the first length.

In an embodiment, the first gate insulating layer may cover the first channel region, the first source region, and the first drain region.

In an embodiment, the second gate insulating layer may be disposed only on a part of the second active layer including the second channel region, and the second gate insulating layer may expose remaining parts of the second source region and the second drain region except for parts of the second source region and the second drain region overlapping the second gate electrode.

In an embodiment, the first gate electrode may overlap the first source region and the first drain region by a part corresponding to a first ratio among parts overlapping of the first source region and the first drain region the first active layer, the second gate electrode may overlap the second source region and the second drain region by a part corresponding to a second ratio among parts of the second source region and the second drain region overlapping the second active layer, and the second ratio may be greater than the first ratio.

In an embodiment, the first active layer and the second active layer may include a same oxide semiconductor.

According to a second aspect of the invention, a method for manufacturing a display device includes preparing a base layer in which a display area and a non-display area are defined, and forming a first semiconductor pattern and a second semiconductor pattern on the base layer in the display area and the non-display area, respectively, forming a first insulating layer on the base layer to cover the first semiconductor pattern and the second semiconductor pattern, forming a first gate electrode overlapping a part of the first semiconductor pattern and a second gate electrode overlapping a part of the second semiconductor pattern, on the first insulating layer, maintaining the first insulating layer in an unetched state on the first semiconductor pattern in the display area, and etching the first insulating layer to expose a remaining part of the second semiconductor pattern which does not overlap the second gate electrode in the non-display area, and forming a second insulating layer covering the first semiconductor pattern, the second semiconductor pattern, the first insulating layer, the first gate electrode, and the second gate electrode.

In an embodiment, in the forming the first semiconductor pattern and the second semiconductor pattern, the first semiconductor pattern and the second semiconductor pattern may be simultaneously formed using a same oxide semiconductor.

In an embodiment, the method for manufacturing the display device may further include doping impurities into a remaining part of the first semiconductor pattern, which does not overlap the first gate electrode, by using the first gate electrode as a mask.

According to embodiments of the invention, a first transistor may be located in a display area and a second transistor may be located in a non-display area may be configured to have different structures from each other based on operation characteristics desired for the respective transistors. For example, the first transistor included in a pixel may be formed to have a structure in which a first gate insulating layer entirely covers a first active layer to thereby prevent, reduce, or minimize a parasitic capacitance of the first transistor, whereas the second transistor included in a driving circuit may be formed to have a structure in which a second gate insulating layer is etched to expose a second source region and a second drain region to thereby increase carrier mobility of the second transistor. According to embodiments of the invention, deterioration of image quality due to the parasitic capacitance of the pixel may be effectively prevented, and output characteristics of the driving circuit may be substantially improved. Accordingly, it is possible to improve the image quality of the display device and improve the operation characteristics and reliability of the display device.

In some embodiments, the first transistor and the second transistor may be formed by using a same oxide semiconductor. For example, active layers of the first transistor and the second transistor may be simultaneously formed by using a same oxide semiconductor. Accordingly, manufacturing efficiency of the display device may be increased, and manufacturing cost may be reduced.

However, effects according to the embodiments of the invention are not limited to those described above and various other effects are incorporated herein.

### BRIEF DESCRIPTION OF THE DRAWINGS

The above and other features of the invention will become more apparent by describing in detail embodiments thereof with reference to the accompanying drawings, in which:
FIG. 1 is a plan view illustrating a display device according to an embodiment;
FIG. 2 is a circuit diagram showing a pixel according to an embodiment;
FIG. 3 is a diagram illustrating a driving circuit included in a first driver according to an embodiment;
FIG. 4 is a circuit diagram illustrating a stage of a driving circuit according to an embodiment
FIG. 5 is a cross-sectional view illustrating a display panel according to an embodiment;
FIG. 6 is an enlarged cross-sectional view of a first area where the first transistor is disposed according to an embodiment;
FIG. 7 is an enlarged cross-sectional view of the first area where the first transistor is disposed according to an embodiment;
FIG. 8 is an enlarged cross-sectional view of a second area where the second transistor is disposed according to an embodiment;
FIG. 9 is a cross-sectional view illustrating a display panel according to an embodiment;
FIG. 10 is a cross-sectional view illustrating the display panel according to an embodiment;
FIGS. 11 to 16 are cross-sectional views illustrating a method for manufacturing a display device according to an embodiment; and
FIG. 17 is a cross-sectional view illustrating a method for manufacturing a display device according to an embodiment.

### DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this invention will be thorough and complete, and will filly convey the scope of the invention to those skilled in the art.

It will also be understood that when an element or a layer is referred to as being "on" another element or layer, it can be directly on the other element or layer, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Features of each of various embodiments of the invention may be partially or entirely combined with each other and may technically variously interwork with each other, and respective embodiments may be implemented independently of each other or may be implemented together in association with each other.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

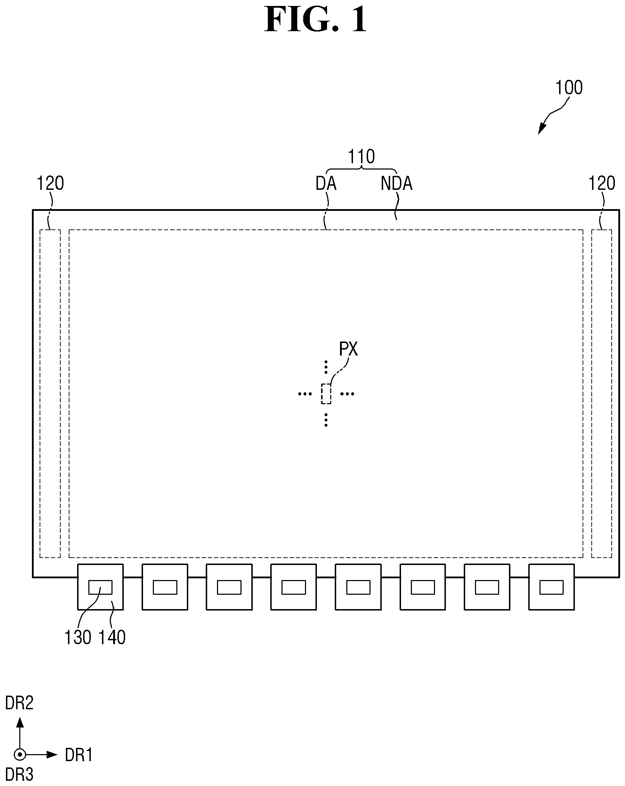

FIG. 1 is a plan view illustrating a display device 100 according to an embodiment.

Referring to FIG. 1, an embodiment of a display device 100 is a device for displaying a moving image or a still image. The display device 100 may be applied to various electronic devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC). These are merely examples, and the display device 100 may be applicable to various other types of electronic device.

In an embodiment, the display device 100 may be a light emitting display device such as an organic light emitting display using an organic light emitting diode, a quantum dot light emitting display including a quantum dot light emitting layer, an inorganic light emitting display including an inorganic semiconductor, and a micro or nano light emitting display using a micro or nano light emitting diode (LED). Hereinafter, for convenience of description, embodiments where the display device 100 is an organic light emitting display device will be described for an example. However, the type of the display device 100 is not limited thereto.

In an embodiment, the display device 100 may include a display panel 110 including pixels PX, and a first driver 120 and a second driver 130 configured to supply driving signals to the pixels PX. The display device 100 may further include additional components. For example, the display device 100 may further include a power supply unit for supplying power voltages to the pixels PX, the first driver 120, and the second driver 130; and a timing controller for controlling the operations of the first driver 120 and the second driver 130.

In an embodiment, the display panel 110 may include a display area DA and a non-display area NDA (also referred to as a "bezel area"). The display area DA may be an area including the pixels PX to display an image. The non-display area NDA is an area other than the display area DA, and an image may not be displayed in the non-display area NDA. In an embodiment, the non-display area NDA may be positioned around the display area DA and may surround the display area DA.

In an embodiment, the display panel 110 may have a rectangular shape in a plan view. For example, the display panel 110 may include two first sides extending in a first direction DR1 and two second sides extending in a second direction DR2 intersecting the first direction DR1. A corner where the first side and the second side of the display panel 110 meet may have a right angle. However, the invention is not limited thereto, and the corner may have a curved surface. In an embodiment, the first side may be longer than the second side, but is not limited thereto.

The first direction DR1, the second direction DR2, and a third direction DR3 are defined in FIG. 1. The first direction DR1 and the second direction DR2 may be perpendicular to each other, the first direction DR1 and the third direction DR3 may be perpendicular to each other, and the second direction DR2 and the third direction DR3 may be perpendicular to each other. The first direction DR1 may mean a horizontal direction in the drawing, and the second direction DR2 may mean a vertical direction in the drawing. The third direction DR3 may mean an upward direction (or a thickness or height direction of the display panel 110) in the drawing.

The planar shape of the display panel 110 is not limited to those described above, but may have a circular shape or other shapes. Further, although FIG. 1 illustrates an embodiment where the display panel 110 is formed to be flat, the embodiments are not limited thereto. In an alternative embodiment, for example, the display panel 110 may include a curved portion that is bent with a predetermined curvature. The display panel 110 may be rigid or flexible.

At least one surface of the display panel 110 may be a display surface on which an image is displayed. For example, the display panel 110 may include a display surface (e.g., an upper surface) placed on one side thereof, or display surfaces (e.g., an upper surface and a lower surface) placed on opposite sides thereof.

The first driver 120 and the second driver 130 may generate driving signals for controlling operation timing, luminance, and the like of the pixels PX, and may supply the generated driving signals to the pixels PX. In an embodiment, for example, the first driver 120 may be a gate driver including a scanning driver, and may supply respective gate signals (for example, driving signals for controlling operation timing of the pixels PX, including a first gate signal GW) to the pixels PX. The second driver 130 may be a data driver including source driving circuits, and may supply respective data signals to the pixels PX.

In an embodiment, at least one first driver of the first driver 120 or the second driver 130, or a part of the at least one first driver may be embedded in the display panel 110. For example, the first driver 120 or a part of the first driver 120 may be disposed or formed in the non-display area NDA of the display panel 110.

Although FIG. 1 illustrates an embodiment where the first driver 120 is formed on both sides of the display area DA (for example, in the non-display area NDA on the left side and the right side of the display area DA), the invention is not limited thereto. In an alternative embodiment, for example, the first driver 120 may be disposed only on one side of the display area DA. In another alternative embodiment, a part of the first driver120 (for example, some of circuit elements constituting the first driver 120) are located in the non-display area NDA, and another portion of the first driver 120 (for example, the rest of the circuit elements constituting the first driver 120) may be located in a non-emission area (for example, an area between emission areas of the pixels PX) provided in the display area DA.

In an embodiment, the other driver of the first driver 120 and the second driver 130 or a part of the other driver may be disposed or formed outside the display panel 110 to be connected to the display panel 110. For example, the second driver 130 or a part of the second driver 130 may be implemented by a multiple number of integrated circuit chips, and may be placed on a circuit board 140 (for example, a flexible circuit board) electrically connected to the pixels PX of the display panel 110.

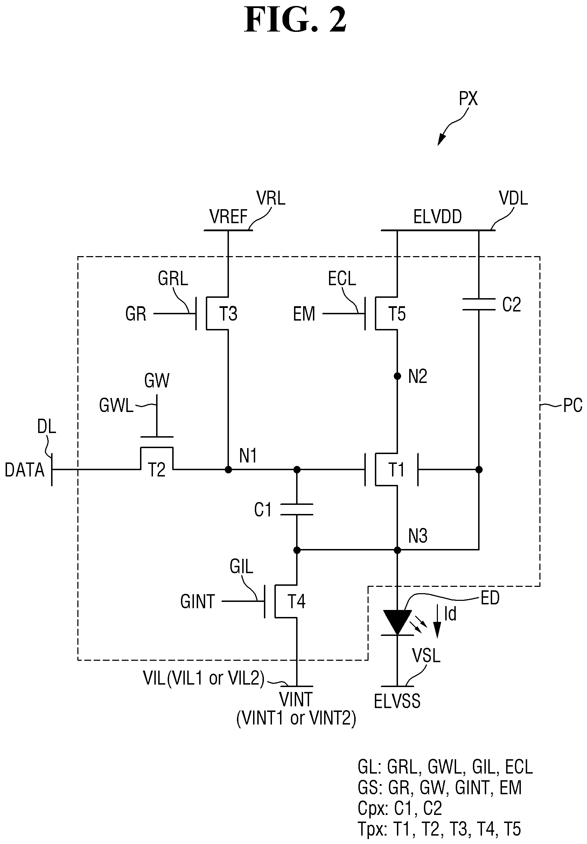

FIG. 2 is a circuit diagram showing a pixel PX according to an embodiment. The pixel PX of FIG. 2 is merely presented as one example, and the structure or type of the pixel PX may be changed in various ways according to embodiments.

Referring to FIG. 2 in addition to FIG. 1, an embodiment of the pixel PX may include a light emitting element ED, and a pixel circuit PC electrically connected to the light emitting element ED. The light emitting element ED is a light source of the pixel PX, and the light emitting element ED may be, for example, an organic light emitting diode, but is not limited thereto. The pixel circuit PC may control the emission time point and the luminance of the light emitting element ED.

The pixel circuit PC may include pixel transistors Tpx (also referred to as "transistors of a first group" or "transistors of the display area DA"), and at least one pixel capacitor Cpx. For example, the pixel circuit PC may include first to fifth pixel transistors T1 to T5, and first and second pixel capacitors C1 and C2. The structure of the pixel circuit PC or the types of the circuit elements constituting the pixel circuit PC may be changed in various ways according to embodiments.

The pixel circuit PC may supply a driving current Id to the light emitting element ED in response to the driving signals supplied from the first driver 120 and the second driver 130. For example, the pixel circuit PC may supply the driving current Id to the light emitting element ED in response to respective gate signals GS supplied from the first driver 120 through respective gate lines GL and a data signal DATA supplied from the second driver 130 through a data line DL.

The first pixel transistor T1 may be a driving element of the pixel PX, in which a magnitude of a source-drain current is determined based on a gate-source voltage. The second to fifth pixel transistors T2 to T5 may be switching elements that are turned on or off based on gate-source voltages thereof (substantially, their own gate voltages). Depending on the type (for example, P-type or N-type) and/or operating conditions of each of the first to fifth pixel transistors T1 to T5, a first electrode of each of the first to fifth pixel transistors T1 to T5 may be a source electrode (or a source region), or a drain electrode (or a drain region), and a second electrode thereof may be an electrode different from the first electrode. In an embodiment, for example, where the first electrode is a source electrode, the second electrode may be a drain electrode.

The pixel PX may be connected to a first gate line GWL that transmits the first gate signal GW (e.g., a scan signal), a second gate line GIL that transmits a second gate signal GINT, a third gate line GRL that transmits a third gate signal GR, an emission control line ECL that transmits an emission control signal EM, and the data line DL that transmits the data signal DATA. In addition, the pixel PX may be connected to a first driving power line VDL for transmitting a first driving voltage ELVDD and a second driving power line VSL for transmitting a second driving voltage ELVSS. In an embodiment, the pixel PX may be connected to an initialization power line VIL for transmitting an initialization voltage VINT and a reference power line VRL for transmitting a reference voltage VREF. In an embodiment, the initialization power line VIL may include a plurality of initialization power lines VIL (e.g., a first initialization power line VIL1 and a second initialization power line VII,2) for transmitting the initialization voltages VINT having different magnitudes (e.g., a first initialization voltage VIL1 and a second initialization power line VIL2). Herein, the term "connection" may include the meaning of "electrical connection."

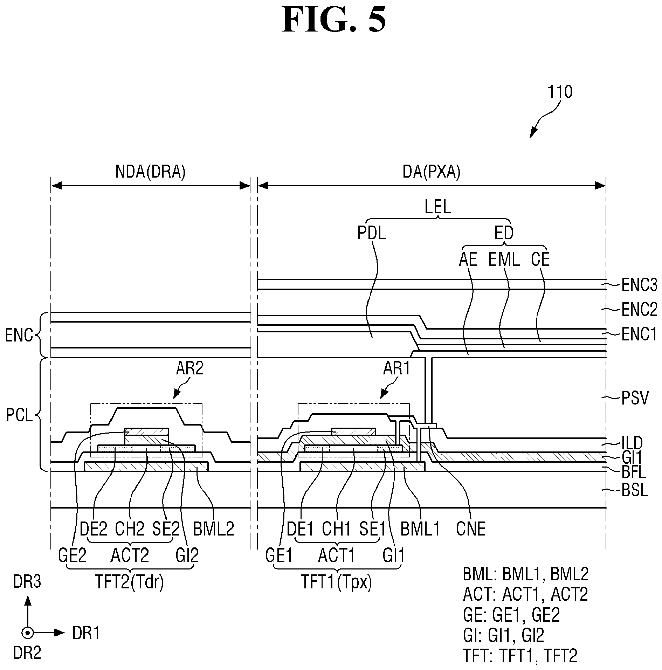

In an embodiment, the first to fifth pixel transistors T1 to T5 may be located in respective pixel areas (e.g., a pixel area PXA of any one pixel PX provided in the display area DA of FIG. 5), and may be oxide transistors (also referred to as "oxide semiconductor transistors") including an oxide semiconductor (e.g., an oxide semiconductor material). In an embodiment, for example, an active layer of each of the first to fifth pixel transistors T1 to T5 may include or be formed of the oxide semiconductor.

The oxide semiconductor has high carrier mobility (for example, high electron mobility in the case of an N-type transistor) and low leakage current, so even if a driving time is long, a voltage drop is not large. That is, in embodiments where the active layer includes an oxide semiconductor, since a color change of an image due to a voltage drop is not large even during low-frequency driving, low-frequency driving may be effectively performed. Therefore, by forming the first to fifth pixel transistors T1 to T5 with the oxide semiconductor, generation of a leakage current may be effectively prevented and power consumption of the display device 100 may be substantially reduced.

The oxide semiconductor is sensitive to light, so that a fluctuation in current amount and the like may occur due to light from the outside. In an embodiment, operation characteristics of the first to fifth pixel transistors T1 to T5 may be stabilized by disposing a light blocking layer (for example, a lower metal layer BML of FIG. 5) under the oxide semiconductor constituting the first to fifth pixel transistors T1 to T5 (or at least one of the first to fifth transistors T1 to T5).

In an embodiment, the metal layer located under the oxide semiconductor of the first pixel transistor T1 may function as a counter gate electrode. For example, the first pixel transistor T1 may be a double-gate transistor having two gate electrodes (for example, a gate electrode and a counter gate electrode). The gate electrode and the counter gate electrode of the first pixel transistor T1 may be disposed to face each other on different layers. For example, the first pixel transistor T1 is an N-type oxide semiconductor transistor, and the gate electrode and the counter gate electrode of the first pixel transistor T1 may be positioned to face each other with an active layer made of an oxide semiconductor therebetween. In an embodiment, the counter gate electrode of the first pixel transistor T1 may be connected to the source electrode of the first pixel transistor T1. In an embodiment, at least one of the second to fifth pixel transistors T2-T5 may also be a double-gate transistor.

The first pixel transistor T1 may include a gate electrode connected to a first node N1 (or a gate node), a first electrode (for example, a drain electrode or a drain region) connected to a second node N2, and a second electrode (for example, a source electrode or a source region) connected to a third node N3. In an embodiment, the first pixel transistor T1 may further include a counter gate electrode connected to the third node N3. For example, the counter gate electrode of the first pixel transistor T1 may be connected to the second electrode of the first pixel transistor T1 to be controlled by a voltage applied to the second electrode of the first pixel transistor T1, and may improve the output saturation characteristics of the first pixel transistor T1. The first electrode of the first pixel transistor T1 may be connected to the first driving power line VDL via the fifth transistor T5, and the second electrode thereof may be connected to the light emitting element ED. The first pixel transistor T1 may function as a driving element of the pixel PX, and may control the magnitude (for example, the amount of current) of the driving current Id flowing to the light emitting element ED in response to the data signal DATA transmitted by the switching operation of the second pixel transistor T2.

The second pixel transistor T2 may include a gate electrode connected to the first gate line GWL, a first electrode connected to the data line DL, and a second electrode connected to the first node N1. The second pixel transistor T2 may be turned on according to the first gate signal GW transmitted through the first gate line GWL to electrically connect the data line DL with the first node N1. Accordingly, the data signal DATA transmitted through the data line DL may be sent to the first node N1.

The third pixel transistor T3 may include a gate electrode connected to the third gate line GRL, a first electrode connected to the reference power line VRL, and a second electrode connected to the first node N1. The third pixel transistor T3 may be turned on in response to the third gate signal GR transmitted through the third gate line GRL and transmit the reference voltage VREF transmitted to the reference power line VRL to the first node N1.

The fourth pixel transistor T4 may include a gate electrode connected to the second gate line GIL, a first electrode connected to the third node N3, and a second electrode connected to the initialization power line VIL. The fourth pixel transistor T4 may be turned on in response to the second gate signal GINT transmitted through the second gate line GIL and transmit the initialization voltage VINT transmitted to the initialization power line VIL to the third node N3.

The fifth pixel transistor T5 may include a gate electrode connected to the emission control line ECL, a first electrode connected to the first driving power line VDL, and a second electrode connected to the second node (or the first electrode of the first pixel transistor T1). The fifth pixel transistor T5 may be turned on or off in response to the emission control signal EM transmitted through the emission control line ECL to control the emission time point of the pixel PX.

The first pixel capacitor C1 may be connected between the first node N1 and the third node N3. For example, the first pixel capacitor C1 may be connected between the second electrode and the gate electrode of the first pixel transistor T1. The first pixel capacitor C1 is a storage capacitor of the pixel PX, and may store therein a threshold voltage of the first pixel transistor T1 and a voltage corresponding to the data signal DATA.

The second pixel capacitor C2 may be connected between the first driving power line VDL and the third node N3. The capacitance of the second pixel capacitor C2 may be less than the capacitance of the first pixel capacitor C 1.

The light emitting element ED may be connected between the third node N3 and the second driving power line VSL. For example, the light emitting element ED may include a first electrode (for example, an anode electrode or a pixel electrode), and a second electrode (for example, a cathode electrode or a counter electrode) opposite to the first electrode. The first electrode of the light emitting element ED may be connected to the third node N3 to receive the driving current Id. The second electrode of the light emitting element ED may be connected to the second driving power line VSL to receive the second driving voltage ELVSS. In an embodiment, the second electrode of the light emitting element ED may be a common electrode shared by the pixels PX. The light emitting element ED may emit light with a luminance corresponding to the driving current Id during a time period in which the driving current Id is supplied from the pixel circuit PC.

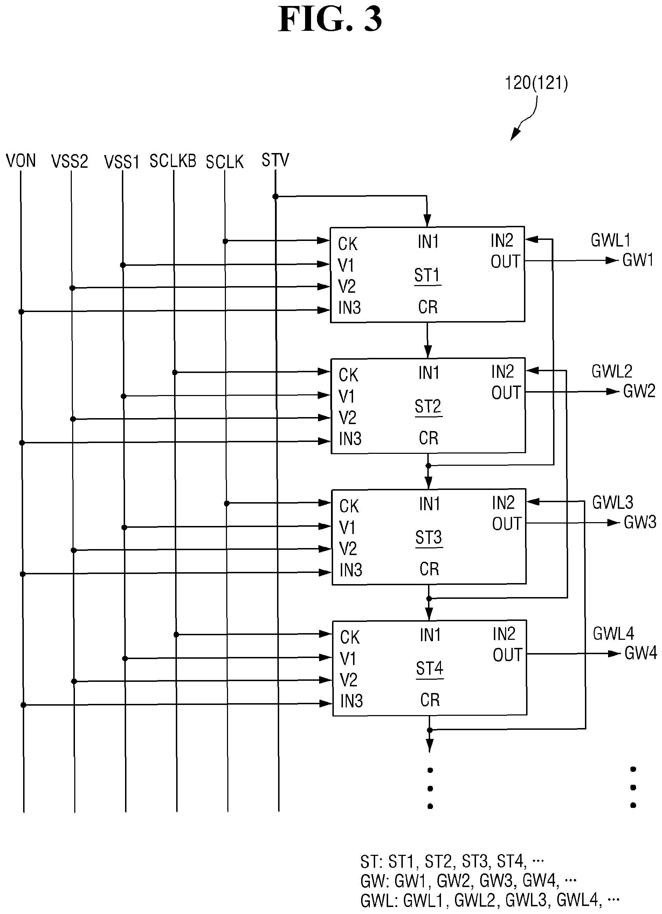

FIG. 3 is a diagram illustrating a driving circuit 121 included in the first driver 120 according to an embodiment. FIG. 3 illustrates one type of driving circuit 121 included in the first driver 120 (or constituting the first driver 120) as an example for showing the configuration of the first driver 120. In an embodiment, the driving circuit 121 may be a scanning driving circuit (or a scanning driver) that generates the first gate signals GW of the pixels PX, but is not limited thereto. Additionally, the driving circuit 121 of FIG. 3 is illustrated as an example, and the type, structure, and/or number of the first driver 120 or the driving circuit 121 constituting the first driver 120 may be changed or modified in various ways according to embodiments.

In the following description, the term "previous stages (or previous-step stages)" may refer to stages that generate the first gate signals GW whose phase is faster than the first gate signal GW outputted at a specific stage as a reference. Also, the term "next stages (or next-step stages)" refers to stages that generate the first gate signals GW whose phase is later than the first gate signal GW outputted at the specific stage as the reference.

Referring to FIG. 3 in addition to FIGS. 1 and 2, an embodiment of the driving circuit 121 may include a plurality of stages ST.

Each of the stages ST may receive multiple driving voltages and multiple external signals. The stages ST may output the respective first gate signals GW based on the multiple driving voltages (or power voltages) and the multiple external signals inputted thereto. Here, the multiple driving voltages may include a control voltage VON as a high-potential voltage, a first power voltage VSS1 as a first low-potential voltage, or a second power voltage VSS2 as a second low-potential voltage VSS2, but are not limited thereto. In addition, the multiple external signals may include a scan start signal STV, a carry signal inputted from the previous stage, a reset signal inputted from the next stage, or a scan clock signal (e.g., a first scan clock signal SCLK and a second scan clock signal SCLKB), but are not limited thereto. In an embodiment, the second power voltage VSS2 may have a potential lower than that of the first power voltage VSS1.

The first gate signal GW outputted from each stage ST (for example, a first gate signal GW1 outputted from a first stage ST1 of FIG. 3) may be supplied to the next stage (for example, a second stage ST2) as a carry signal. Each stage ST may output the first gate signal GW to the gate line GWL connected thereto in response to a carry signal (e.g., a first carry signal) inputted from the previous stage. Among the stages ST, the first stage ST1 may receive the scan start signal STV from the outside as the carry signal.

The first gate signal GW outputted from each stage ST may be supplied to the previous stage as a reset signal (e.g., a second carry signal). Each stage ST may transit the potential of an output node from a high-potential voltage to a first low-potential voltage in response to the reset signal inputted from the next stage.

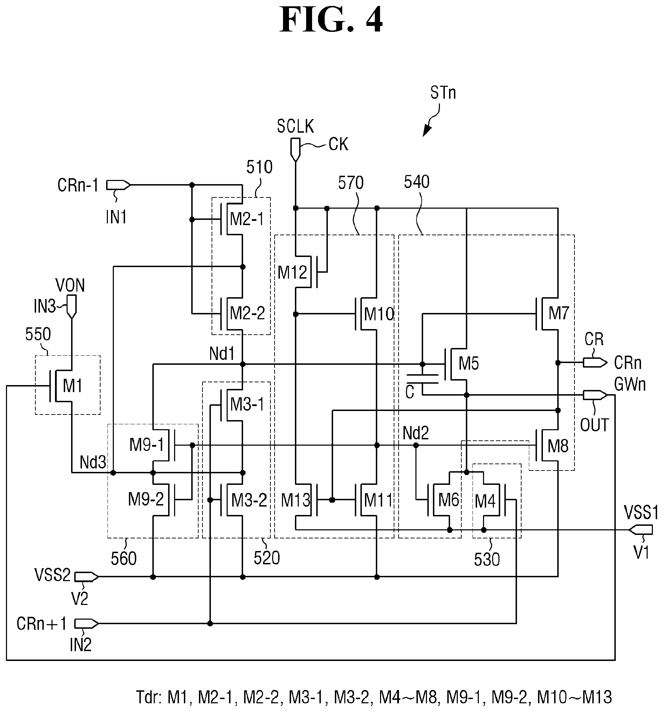

The stages ST may output the first gate signals GW in response to the scan start signal STV. For example, the stages ST may sequentially output the first gate signals GW to the first gate lines GWL in response to the scan start signal STV. For example, an n^{th} stage (for example, the n^{th} stage STn of FIG. 4, where n is a natural number) may output an n^{th} first gate signal GW (for example, the n^{th} scan signal GWn of FIG. 4) to the n^{th} first gate line GWL. The scan start signal STV for controlling the output timing of the first gate signal GW1 (for example, a first scan signal) may be supplied to the first stage ST1.

Each of the stages ST may include a first input terminal IN1, a second input terminal IN2, a third input terminal IN3, a scan clock input terminal CK, a first power input terminal V1, a second power input terminal V2, a carry output terminal CR, and an output terminal OUT.

Each of the stages ST may receive the first scan clock signal SCLK or the second scan clock signal SCLKB through the scan clock input terminal CK. For example, the odd-numbered stages ST1, ST3, ... may receive the first scan clock signal SCLK, while the even-numbered stages ST2, ST4, ... may receive the second scan clock signal SCLKB.

The first scan clock signal SCLK may be a square wave signal that repeats a logic high level and a logic low level. Here, the logic high level may correspond to a gate-on voltage, and the logic low level may correspond to a gate-off voltage. For example, the logic high level may be a voltage value in a range of about 10 volts (V) and about 30 V, and the logical low level may be a voltage value in a range of about-16 V and about -3 V.

The second scan clock signal SCLKB may be a square wave signal that repeats the logic high level and the logic low level. In an embodiment, the second scan clock signal SCLKB may be set as a signal having a same cycle as the first scan clock signal SCLK but having an inverted phase. However, this is merely an example, and the waveform relationship between the first scan clock signal SCLK and the second scan clock signal SCLKB is not limited thereto. In an embodiment, for example, a part of the logic high level period of the first scan clock signal SCLK and a part of the logic high level period of the second scan clock signal SCLKB may overlap.

In addition, the number of the scan clock signals supplied to one stage is not limited to the above example. In an alternative embodiment, for example, two or more scan clock signals may be applied to each of the stages ST.

The first input terminal IN1 may receive the scan start signal STV or a carry signal of the previous stage. For example, the scan start signal STV may be applied to the first input terminal IN1 of the first stage ST1, and the carry signal of the previous stage may be applied to the first input terminal IN1 of each of the stages ST2, ST3, ST4, ... other than the first stage ST1.

The second input terminal IN2 may receive a carry signal of the next stage. For example, the carry signal of the next stage may be one of the carry signals supplied after the lapse of a predetermined time from the output of the carry signal of the current stage.

The third input terminal IN3 may receive the control voltage VON. In an embodiment, the control voltage VON may be a high-potential voltage to be supplied to the source electrode of at least one transistor included in each of the stages ST. For example, the control voltage VON may be a constant voltage near the logic high level (e.g., the gate-on voltage) of the first scan clock signal SCLK. For example, the control voltage VON may have a voltage value in a range of about 10 V to about 30 V.

In an embodiment, the control voltage VON may be the same as the scan clock signal SCLK or SCLKB. For example, each of the stages ST may receive the same clock signal through the scan clock input terminal CK and the third input terminal IN3.

The carry output terminal CR may output a carry signal. The carry signal may be provided to the first input terminal IN1 of the next stage.

The output terminal OUT may output the first gate signal GW generated at each stage ST. The first gate signal GW may be supplied to the pixel PX through the first gate line GWL corresponding thereto.

The first power input terminal V1 may be supplied with the first power voltage VSS1, and the second power input terminal V2 may be supplied with the second power voltage VSS2. The first power voltage VSS1 and the second power voltage VSS2 may be set to be the gate-off voltage. In an embodiment, the first power voltage VSS1 and the second power voltage VSS2 may be the same as each other. In an embodiment, the voltage level of the second power supply voltage VSS2 may be less than the voltage level of the first power supply voltage VSS1. For example, the first power voltage VSS1 may be set in a range of about -14 V to about -1 V, and the second power voltage VSS2 may be set in a range of about -16 V to about -3 V.

FIG. 4 is a circuit diagram illustrating a stage ST or STn of the driving circuit 121 according to an embodiment. FIG. 4 shows the n^{th} stage STn included in the aforementioned driving circuit 121 (or constituting the driving circuit 121) as an example for showing the configuration of the driving circuit 121. The n^{th} stage STn shown in FIG. 4 is presented as merely one example, and the structure and/or operation method of the driving circuit 121 or the n^{th} stage STn constituting the driving circuit 121 may be changed in various ways according to embodiments.

Hereinafter, for convenience of description, embodiments where driving transistors Tdr (also referred to as "transistors of a second group" or "transistors of the non-display area NDA") constituting the n^{th} stage STn are N-type transistors will be described in detail, but the type of the driving transistors Tdr is not limited thereto. In an alternative embodiment, for example, at least one of the driving transistors Tdr may be a P-type transistor.

Referring to FIG. 4 in addition to FIGS. 1 to 3, the n^{th} stage STn may include a first input unit 510, a second input unit 520, a first controller (or control unit) 530, an output unit 540, and a leakage controller 550. In an embodiment, the n^{th} stage STn may further include a second controller 560 and a third controller 570.

In an embodiment, the driving transistors Tdr included in the n^{th} stage STn may be located in the non-display area NDA (for example, the non-display area NDA of FIGS. 1 and 5), and the driving transistors Tdr may be oxide transistors including an oxide semiconductor. For example, an active layer of each of the driving transistors Tdr may include or be formed of an oxide semiconductor. In an embodiment, the driving transistors Tdr and the pixel transistors Tpx may be oxide transistors formed by using a same raw oxide semiconductor. For example, active layers of the driving transistors Tdr and the pixel transistors Tpx may include a same oxide semiconductor, and may be disposed in (or directly on) a same layer as each other.

The first input unit 510 may control the voltage of a first node Nd1 in response to the scan start signal SVN or a carry signal CRn-1 of the previous stage supplied to the first input terminal IN1. The voltage of the first node Nd1 is a voltage for controlling the outputs of the n^{th} first gate signal (hereinafter referred to as "n^{th} scan signal GWn") and the n^{th} carry signal CRn. For example, the voltage of the first node Nd1 may be a voltage for controlling the pull-up of the n^{th} carry signal CRn and the n^{th} scan signal GWn.

In an embodiment, the first input unit 510 may include second driving transistors (for example, a first second driving transistor M2-1 and a second second driving transistor M2-2) connected to each other in series between the first input terminal IN1 and the first node Nd1. Gate electrodes of the second driving transistors M2-1 and M2-2 may be connected to the first input terminal IN1 in common. For example, the second driving transistors M2-1 and M2-2 may have a dual-gate structure, and each of the second driving transistors M2-1 and M2-2 may have a diode connection structure. The first input unit 510 may transmit the gate-on voltage (e.g., logic high level) of the (n-1)^{th} carry signal CRn-1 to the first node Nd1. For example, the first input unit 510 may pre-charge the voltage of the first node Nd1 based on the gate-on voltage of the (n-1)^{th} carry signal CRn-1.

A common node between the second driving transistors M2-1 and M2-2 may correspond to the third node Nd3. For example, the common node between the second driving transistors M2-1 and M2-2 may be connected to the third node Nd3.

In case that the voltage of the first node Nd1 is high at the level of the gate-on voltage, a leakage current may be generated from the first node Nd1 to the first input unit 510 if the voltage of the common node between the second driving transistors M2-1 and M2-2 is lower than a predetermined reference value. In addition, if the threshold voltage is negatively shifted due to degradation of the second driving transistors M2-1 and M2-2, a leakage current may be generated from the first node Nd1 to the first input unit 510.

In each oxide transistor, a threshold voltage (Vth) may be shifted to a negative value (i.e., negatively shifted) due to degradation or the like. In this case, the oxide transistor may suffer an increase of the leakage current in a turn-off state, so that the circuit of the stage may operate abnormally.

A high voltage at the level of the gate-on voltage may be applied to the common node between the second driving transistors M2-1 and M2-2 in the state that the first node Nd1 is charged with the gate-on voltage. In this case, the (n-1)^{th} carry signal CRn-1 may have the gate-off voltage, and the gate-off voltage may be supplied to gate electrodes of the second driving transistors M2-1 and M2-2. Therefore, a gate-source voltage (Vgs) of the second second driving transistor M2-2 may be maintained at a very low value (e.g., a negative value), and even if the second driving transistors M2-1 and M2-2 are degraded, a current leakage from the first node Nd1 to the first input unit 510 may be effectively prevented.

The second input unit 520 may control the voltage of the first node Nd1 in response to a reset signal (e.g., an (n+1)^{th} carry signal CRn+1) of the next stage. In an embodiment, the second input unit 520 may provide a voltage of the second power voltage VSS2 to the first node Nd1 in response to the (n+1)^{th} carry signal CRn+1. For example, the second input unit 520 may discharge the voltage of the first node Nd1 having a predetermined high- potential voltage.

The second input unit 520 may include third driving transistors (for example, a first third driving transistor M3-1 and a second third driving transistor M3-2) connected to each other in series between the first node Nd1 and the second power input terminal V2. Gate electrodes of the third driving transistors M3-1 and M3-2 may be connected to the second input terminal IN2 in common.

A common node between the third transistors M3-1 and M3-2 may correspond to the third node Nd3. For example, the common node between the third driving transistors M3-1 and M3-2 may be connected to the third node Nd3.

The first controller 530 may control the voltage of the output terminal OUT that outputs the n^{th} scan signal GWn in response to the (n+1)^{th} carry signal CRn+1. In an embodiment, the first controller 530 may provide a voltage of the first power voltage VSS1 to the output terminal OUT in response to the (n+1)^{th} carry signal CRn+1.

In an embodiment, the first controller 530 may include a fourth driving transistor M4 connected between the output terminal OUT and the first power input terminal V1. A gate electrode of the fourth driving transistor M4 may be connected to the second input terminal IN2. The fourth driving transistor M4 may discharge the voltage of the output terminal OUT to the voltage of the first power supply voltage VSS1.

The output unit 540 may be connected to the scan clock input terminal CK, the first power input terminal V1, and the second power input terminal V2. The output unit 540 may output the n^{th} scan signal GWn corresponding to the scan clock signal SCLK and the n^{th} carry signal CRn to the output terminal OUT and the carry output terminal CR, respectively, in response to the voltage of the first node Nd1 and the voltage of the second node Nd2. The voltage of the second node Nd2 may control the gate-off voltage (logic low level) states of the n^{th} scan signal GWn and the n^{th} carry signal CRn. For example, the voltage of the second node Nd2 may be a voltage for controlling the pull-down of the n^{th} carry signal CRn and the n^{th} scan signal GWn. In an embodiment, the output unit 540 may include fifth to eighth driving transistors M5 to M8 and a driving capacitor C.

The fifth driver transistor M5 may be connected between the scan clock input terminal CK and the output terminal OUT. The fifth driving transistor M5 may include a gate electrode connected to the first node Nd1. The fifth driving transistor M5 may supply the gate-on voltage to the output terminal OUT in response to the voltage of the first node Nd1. For example, the fifth driving transistor M5 may function as a pull-up buffer.

The sixth driving transistor M6 may be connected between the output terminal OUT and the first power input terminal V1. The sixth driving transistor M6 may include a gate electrode connected to the second node Nd2. The sixth driving transistor M6 may supply the gate-off voltage to the output terminal OUT in response to the voltage of the second node Nd2. For example, the sixth driving transistor M6 may hold the voltage of the output terminal OUT at the gate-off voltage level (or logic low level).

The seventh driving transistor M7 may be connected between the scan clock input terminal CK and the carry output terminal CR. The seventh driving transistor M7 may include a gate electrode connected to the first node Nd1. The seventh driving transistor M7 may supply the gate-on voltage to the carry output terminal CR in response to the voltage of the first node Nd1. For example, the seventh driving transistor M7 may function as a pull-up buffer.

The eighth driving transistor M8 may be connected between the carry output terminal CR and the second power input terminal V2. The eighth driving transistor M8 may include a gate electrode connected to the second node Nd2. The eighth driving transistor M8 may supply the gate-off voltage to the carry output terminal CR in response to the voltage of the second node Nd2. For example, the eighth driving transistor M8 may hold the voltage of the carry output terminal CR at the gate-off voltage level (i.e., logic low level).

The driving capacitor C may be connected between the first node Nd1 and the output terminal OUT. The driving capacitor C may function as a boosting capacitor. For example, the driving capacitor C may raise (bootstrap) the voltage of the first node Nd1 in response to a voltage rise of the output terminal OUT when the fifth driving transistor M5 is turned on. Accordingly, the fifth driving transistor M5 may stably maintain a turn-on state for a predetermined period of time.

The second controller 560 may hold the voltage of the first node Nd1 to a predetermined gate-off voltage in response to the voltage of the second node Nd2. In an embodiment, the second controller 560 may provide a voltage of the second power voltage VSS2 (i.e., the gate-off voltage) to the first node Nd1 in response to the voltage of the second node Nd2.

In an embodiment, the second controller 560 may include ninth driving transistors (e.g., a first ninth driving transistor M9-1 and a second ninth driving transistor M9-2) connected to each other in series between the first node Nd1 and the second power input terminal V2. Gate electrodes of the ninth driving transistors M9-1 and M9-2 may be connected to the second node Nd2 in common.

A common node between the ninth driving transistors M9-1 and M9-2 may correspond to the third node Nd3. For example, the common node between the ninth driving transistors M9-1 and M9-2 may be electrically connected to the third node Nd3.

Although an embodiment where the two second driving transistors M2-1 and M2-2, the two third driving transistors M3-1 and M3-2, and the two ninth driving transistors M9-1 and M9-2 are provided are illustrated in FIG. 4, the number of the driving transistors Tdr connected in series is not limited thereto. In an alternative embodiment, for example, where three or more third driving transistors are connected to each other in series, at least one common node between these third driving transistors may be electrically connected to the third node Nd3.

The third controller 570 may control the voltage of the second node Nd2 in response to the scan clock signal SCLK and the n^{th} carry signal CRn. In an embodiment, the third controller 570 may transmit the scan clock signal SCLK to the second node Nd2 in response to the scan clock signal SCLK, and then supply the gate-off voltage to the second node Nd2 in response to the n^{th} carry signal CRn.

The voltage of the second node Nd2 may control the gate-off voltage (logic low level) states of the n^{th} scan signal GWn and the n^{th} carry signal CRn.

The third controller 570 may include tenth to thirteenth driving transistors M10 to M13.

The tenth driving transistor M10 may be connected between the scan clock input terminal CK and the second node Nd2. A gate electrode of the tenth driving transistor M10 may be connected to a common node of the twelfth and thirteenth driving transistors M12 and M13. The tenth driving transistor M10 may supply the scan clock signal SCLK to the second node Nd2 in response to the scan clock signal SCLK.

The eleventh driving transistor M11 may be connected between the second node Nd2 and the second power input terminal V2.

The twelfth and thirteenth driving transistors M12 and M13 may be connected to each other in series between the scan clock input terminal CK and the first power input terminal V1. A gate electrode of the twelfth driving transistor M12 may be connected to the clock input terminal CK. Gate electrodes of the eleventh and thirteenth driving transistors M11 and M13 may be connected to the carry output terminal CR in common.

When the n^{th} carry signal CRn is outputted (for example, when the n^{th} carry signal CRn has the gate-on voltage), the thirteenth driving transistor M13 is turned on to turn off the tenth driving transistor M10, and the eleventh driving transistor M11 is turned on to supply a voltage of the second power voltage VSS2 to the second node N2. Accordingly, when the n^{th} carry signal CRn is outputted, the second node Nd2 may have a gate-off voltage.

In such an embodiment, the voltage level of the second power voltage VSS2 may be less than the voltage level of the first power voltage VSS1. That is, the voltage of the second power voltage VSS2 lower than the voltage of the first power voltage VSS1 may be provided to the second node Nd2 by the operation of the eleventh driving transistor M11. In such an embodiment, unintended operation of the sixth driving transistor M6 and/or the eighth driving transistor M8 due to the ripple of the voltage of the second node Nd2 may be effectively prevented when the voltage of the second node Nd2 changes from the gate-on voltage to the gate-off voltage. Accordingly, one electrode of the eleventh driving transistor M11 may be connected to the second power voltage VSS2 lower than the voltage of the first power voltage VSS1.

The leakage controller 550 may supply the control voltage VON supplied to the third input terminal IN3 to the first input unit 510, the second input unit 520, and the second controller 560 in response to one of the n^{th} scan signal GWn and the n^{th} carry signal CRn. In an embodiment, the leakage controller 550 may include a first driving transistor M1 connected between the third input terminal IN3 and the third node Nd3. The first driving transistor M1 may include a gate electrode configured to receive the n^{th} scan signal GWn.

The first driving transistor M1 may supply, in response to the n^{th} scan signal GWn, the control voltage VON to common nodes of the driving transistors Tdr respectively connected in series to the first node Nd1. Accordingly, while the first node Nd1 is charged (for example, when the voltage of the first node Nd1 is boosted), the control voltage VON of a high potential may be applied to one electrode of the second driving transistor (e.g., the second second driving transistor M2-2), one electrode of the third driving transistor (e.g., the first third driving transistor M3-1), and one electrode of the ninth driving transistor (e.g., the first ninth driving transistor M9-1). That is, while the first node Nd1 is being charged, the third node Nd3 may be charged with the high-potential voltage by the control voltage VON. Therefore, when the voltage of the first node Nd1 is boosted, the gate-source voltage (Vgs) of each of the second second driving transistor M2-2, the first third driving transistor M3-1, and the first ninth driving transistor M9-1 may have a negative value, and the gate-source voltage (Vgs) of each of the second second driving transistor M2-2, the first third driving transistor M3-1, and the first ninth driving transistor M9-1 may be maintained at a value much smaller than a threshold voltage. Accordingly, leakage of current from the first node Nd1 through the second second driving transistor M2-2, the first third driving transistor M3-1, and the first ninth driving transistor M9-1 may be effectively prevented.

FIG. 5 is a cross-sectional view illustrating the display panel 110 according to an embodiment. Particularly, FIG. 5 illustrates a part of the display area DA and a part of the non-display area NDA of the display panel 110. In FIG. 5, one pixel transistor Tpx (also referred to as "first transistor TFT1") and one driving transistor Tdr (also referred to as "second transistor TFT2") are illustrated as an example of circuit elements that may be provided or placed in a panel circuit layer PCL of the display panel 110.

Referring to FIG. 5 in addition to FIGS. 1 to 4, the display panel 110 may include a base layer BSL (also referred to as "base member"), the panel circuit layer PCL (also referred to as "panel circuit unit" or "circuit layer"), a light emitting element layer LEL (also referred to as a "light emitting element unit" or "light source unit"), and an encapsulation layer ENC (also referred to as "encapsulation unit" or "protection unit"). The panel circuit layer PCL, the light emitting element layer LEL, and the encapsulation layer ENC may be disposed or provided to overlap each other on the base layer BSL. In an embodiment, for example, the panel circuit layer PCL, the light emitting element layer LEL, and the encapsulation layer ENC may be sequentially disposed or formed on one surface of the base layer BSL. However, the embodiments are not limited thereto, and the mutual positions of the panel circuit layer PCL, the light emitting element layer LEL, and the encapsulation layer ENC may be changed according to the embodiments. In an embodiment, the display panel 110 may further include a light control layer (for example, a color filter layer and/or a wavelength conversion layer) provided above and/or below the encapsulation layer ENC, or a passivation layer (for example, a passivation film, an insulating layer, an upper substrate, and/or a window).

The base layer BSL may be a rigid or flexible substrate or film. In an embodiment, the base layer BSL may be a glass substrate or a plastic substrate. For example, the base layer BSL may include at least one selected from a glass substrate, a quartz substrate, a glass ceramic substrate, a film substrate containing a polymer organic material, and a plastic substrate. In an embodiment, for example, the base layer BSL may include a fiber glass reinforced plastic (FRP).

The display area DA and the non-display area NDA may be defined on the base layer BSL. In an embodiment, the pixel areas PXA respectively corresponding to the pixels PX may be defined in the display area DA of the base layer BSL, and a driving circuit area DRA provided with the driving circuit 121 of the first driver 120 may be defined in the non-display area NDA.

The panel circuit layer PCL may include circuit elements including the pixel transistors Tpx and the driving transistors Tdr, and lines (e.g., signal lines and power lines). In an embodiment, the panel circuit layer PCL may further include additional conductive patterns. For example, the panel circuit layer PCL may further include connection electrodes CNE, bridge patterns, or the like.

The pixel transistors Tpx may be included in the pixel circuit PC of each pixel PX, and may be positioned in the display area DA. For example, each pixel transistor Tpx may be disposed in the pixel area PXA in which the corresponding pixel PX is provided or formed. In FIG. 5, for convenience of illustration and description, one pixel transistor Tpx (e.g., the first pixel transistor T1 connected to the light emitting element ED of the corresponding pixel PX) of the pixel transistors Tpx is illustrated, and this will be referred to as "first transistor TFT1."

The driving transistors Tdr may be included in the driving circuit 121 of the first driver 120, and may be located in the non-display area NDA. For example, each driving transistor Tdr may be disposed in the driving circuit area DRA in which the corresponding stage ST is provided or formed. In FIG. 5, for convenience of illustration and description, one driving transistor Tdr (e.g., any one of the fifth to eighth driving transistors Tdr included in the output unit 540 of the n^{th} stage STn) of the driving transistors Tdr is illustrated, and this will be referred to as "second transistor TFT2").

The panel circuit layer PCL may further include a plurality of insulating layers. For example, the panel circuit layer PCL may include a buffer layer BFL, a gate insulating layer GI (also referred to as "first insulating layer" GI), an interlayer insulating layer ILD (also referred to as "second insulating layer" ILD), and a passivation layer PSV (also referred to as "third insulating layer") sequentially disposed or provided on the base layer BSL. Structures and materials of the buffer layer BFL, the gate insulating layer GI, the interlayer insulating layer ILD, and the passivation layer PSV are not particularly limited. For example, each of the buffer layer BFL, the gate insulating layer GI, the interlayer insulating layer ILD, and the passivation layer PSV may be defined by a single layer or multiple layers, and may include at least one organic insulating material and/or inorganic insulating material (e.g., silicon nitride (SiNₓ), silicon oxide (SiOₓ), or silicon oxynitride (SiOₓN_{y}).

In embodiments, some of the pixel transistors Tpx and the driving transistors Tdr and some others thereof may have different structures from each other in terms of the gate insulating layer GI, and may exhibit different operation characteristics depending on their structures. Therefore, in embodiments described herein, the gate insulating layer GI or a part of the gate insulating layer GI may be regarded as being included in each of the pixel transistors Tpx and the driving transistors Tdr.

The panel circuit layer PCL may further include the lower metal layer BML disposed on the base layer BSL. In an embodiment, the panel circuit layer PCL may further include at least one line disposed in (or directly on) a same layer as the lower metal layer BML.

The lower metal layer BML may be disposed between the base layer BSL and the buffer layer BFL, and may be disposed under at least some of transistor elements TFT including the pixel transistors Tpx and the driving transistors Tdr. For example, the lower metal layer BML may include a first lower metal layer BML1 disposed under the first transistor TFT1 and a second lower metal layer BML2 disposed under the second transistor TFT2. Each lower metal layer BML may overlap an active layer ACT of the corresponding transistor element TFT. For example, the first lower metal layer BMI,1 may overlap a first active layer ACT1 included in the first transistor TFT1, and the second lower metal layer BML2 may overlap a second active layer ACT2 included in the second transistor TFT2. In such an embodiment where the lower metal layers BML are disposed under the transistor elements TFT, a fluctuation of a current that might be caused by external light may be effectively prevented, and the operation characteristics of the transistor elements TFT may be stabilized.

The lower metal layers BML may include at least one metal selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W) and copper (Cu), but are not limited thereto. In an alternative embodiment, for example, the lower metal layers BML may include other materials other than the materials mentioned above.

In an embodiment, at least one of the lower metal layers BML may be connected to the corresponding transistor element TFT. For example, the first lower metal layer BML1 may be electrically connected to a first source region SE1 (or a source electrode) of the first transistor TFT1 through the connection electrode CNE. In this case, the first lower metal layer BMI,1 may be regarded as being included in the first transistor TFT1, or may be regarded as being connected to the first transistor TFT1 as a separate component from the first transistor TFT1.

The buffer layer BFL may be disposed on one surface of the base layer BSL to cover the lower metal layers BML. The buffer layer BFL may prevent diffusion of impurities to each circuit element.

Circuit elements and/or lines including transistor elements TFT may be disposed on the buffer layer BFL. For example, the pixel transistors Tpx including the first transistor TFT1 and the pixel capacitors (e.g., the pixel capacitors Cpx of FIG. 2) may be disposed in the display area DA on the buffer layer BFL, and the driving transistors Tdr including the second transistor TFT2 and the driving capacitors (e.g., the driving capacitor C of FIG. 2) may be disposed in the non-display area NDA on the buffer layer BFL.

Each transistor element TFT may include the active layer ACT, the gate insulating layer GI, and a gate electrode GE. For example, the first transistor TFT1 may include the first active layer ACT1, a first gate insulating layer GI1, and a first gate electrode GE1, and the second transistor TFT2 may include the second active layer ACT2, a second gate insulating layer GI2, and a second gate electrode GE2.

In an embodiment, the first transistor TFT1 and the second transistor TFT2 may be oxide transistors including an oxide semiconductor. For example, the first active layer ACT1 and the second active layer ACT2 may be formed by using an oxide semiconductor. In an embodiment, the first active layer ACT1 and the second active layer ACT2 may include a same oxide semiconductor as each other. For example, by simultaneously forming the first active layer ACT1 and the second active layer ACT2 in (or directly on) a same layer (e.g., on top of the buffer layer BFL) by using a same raw oxide semiconductor, the manufacturing cost of the display device 100 can be reduced and manufacturing efficiency can be increased.

The oxide semiconductor used to form the first transistor TFT1 and the second transistor TFT2 may include a metal oxide including a metal such as zinc (Zn), indium (In), gallium (Ga), tin (Sn), or titanium (Ti), or a combination of a metal such as zinc (Zn), indium (In), gallium (Ga), tin (Sn), or titanium (Ti) and an oxide thereof. For example, the oxide semiconductor may include at least one selected from zinc oxide (ZnO), zinc-tin oxide (ZTO), zinc-indium oxide (ZIO), indium oxide (InO), titanium oxide (TiO), indium-gallium oxide (IGO), indium-gallium-zinc oxide (IGZO), indium-zinc-tin oxide (IZTO), and indium-tin-gallium-zinc oxide (ITGZO). The oxide semiconductor used to form the transistor elements TFT is not limited to the materials exemplified above, and may be variously changed according to embodiments.

The first active layer ACT1 may be disposed on the buffer layer BFL, and may include a first channel region CH1, and the first source region SE1 and a first drain region DE1 spaced apart from each other with the first channel region CH1 therebetween. For example, the first source region SE1 and the first drain region DE1 may be located at opposing sides of the first channel region CH1. The first channel region CH1 may be a region that maintains semiconductor characteristics without becoming conductive, and the first source region SE1 and the first drain region DE1 may be regions that have become conductive.

In an embodiment, the first source region SE1 may also function as a source electrode of the first transistor TFT1, and the first drain region DE1 may also function as a drain electrode of the first transistor TFT1. In an alternative embodiment, the first transistor TFT1 may further include a separate source electrode connected to the first source region SE1 and/or a separate drain electrode connected to the first drain region DE 1.

The first gate insulating layer GI1 is disposed on the first active layer ACT1. In an embodiment, the first gate insulating layer GI1 may have a shape that is not etched at least in a region where the first transistor TFT1 is formed and the vicinity thereof. For example, the first gate insulation layer GI1 may cover the first active layer ACT1 entirely, except for a contact portion for electrical connection between elements (e.g., a contact hole formed in the first gate insulation layer GI1 to connect the first transistor TFT1 to the connection electrode CNE and/or the light emitting element ED). For example, the first gate insulating layer GI1 may be formed in a shape that covers the first active layer ACT1 entirely at least in a region where the first transistor TFT1 is formed, to thereby cover the first channel region CH1, the first source region SE1, and the first drain region DE1. In an embodiment, the first gate insulating layer GI1 may be formed in the entire display area DA.

In case that the first gate insulating layer GI1 covers the first active layer ACT1 entirely, the parasitic capacitance that may be formed between the first gate electrode GE1 and the first source region SE1 and the first drain region DE1 may effectively be prevented, substantially reduced, or minimized. Accordingly, the parasitic capacitance may be effectively prevented or minimized from affecting the operation of the first transistor TFT1, while allowing each pixel PX to emit light with uniform luminance in response to the data signal DATA. Accordingly, an occurrence of image stains due to the parasitic capacitance may be effectively prevented, substantially reduced or minimized, thus improving the image quality of the display device 100.

The first gate electrode GE1 is disposed on the first gate insulating layer GI1. The first gate electrode GE1 may overlap a part of the first active layer ACT1. For example, the first gate electrode GE1 may be disposed on the first channel region CH1 to overlap the first channel region CH1. The first gate electrode GE1 may or may not partially overlap the first source region SE1 and the first drain region DE1. For example, the first gate electrode GE1 may be disposed only on a part of the first active layer ACT1 including the first channel region CH1.

The second active layer ACT2 may be disposed on the buffer layer BFL, and may include a second channel region CH2, and a second source region SE2 and a second drain region DE2 spaced apart from each other with the second channel region CH2 therebetween. For example, the second source region SE2 and the second drain region DE2 may be located at opposing sides of the second channel region CH2. The second channel region CH2 may be a region that maintains semiconductor characteristics without becoming conductive, and the second source region SE2 and the second drain region DE2 may be regions that have become conductive.

In an embodiment, the second source region SE2 may also function as a source electrode of the second transistor TFT2, and the second drain region DE2 may also function as a drain electrode of the second transistor TFT2. In an alternative embodiment, the second transistor TFT2 may further include a separate source electrode connected to the second source region SE2 and/or a separate drain electrode connected to the second drain region DE2.

The second gate insulating layer GI2 is disposed on the second active layer ACT2. In an embodiment, the second gate insulating layer GI2 may have a shape etched to expose at least a part of each of the second source region SE2 and the second drain region DE2. For example, the second gate insulating layer GI2 may be disposed only on a part of the second active layer ACT2 including the second channel region CH2, and may expose the second source region SE2 and the second drain region DE2. For example, the second gate insulating layer GI2 may expose the remaining parts of the second source region SE2 and the second drain region DE2 except for parts thereof overlapping the second gate electrode GE2. In an embodiment, the second gate insulating layer GI2 may be locally disposed on the active layer ACT included in each of at least some of the transistor elements TFT (for example, the driving transistors Tdr including the second transistor TFT2) located in the non-display area NDA.

In such an embodiment where the second gate insulating layer GI2 has a shape etched to expose the second source region SE2 and the second drain region DE2, the length, width, and/or area of the second source region SE2 and the second drain region DE2 may be expanded in a process of forming the second transistor TFT2 and/or a subsequent process thereafter to enhance conductivity. When the length, width, and/or area of the second source region SE2 and the second drain region DE2 are expanded, the length of the second channel region CH2 may be relatively reduced.

Accordingly, the carrier mobility (e.g., electronic mobility) of the second transistor TFT2 may be increased and operation characteristics (for example, a switching characteristic and/or a response speed) thereof may be improved. Accordingly, output characteristics of the driving circuit 121 may be improved. In addition, as the output characteristics of the driving circuit 121 are improved, image stains that might be caused by malfunction of the driving circuit 121 or a decrease in the response speed thereof can be effectively prevented or substantially reduced, and pixels PX can be stably driven (for example, a threshold voltage margin may be secured). Accordingly, the operation of the display device 100 may be stabilized, and the image quality may be improved.

The second gate electrode GE2 may be disposed on the second gate insulating layer GI2. The second gate electrode GE2 may overlap a part of the second active layer ACT2. For example, the second gate electrode GE2 may be disposed on the second channel region CH2 to overlap the second channel region CH2. In an embodiment, the second gate electrode GE2 may partially overlap the second source region SE2 and the second drain region DE2. For example, the second source region SE2 and the second drain region DE2 may extend to an area where the second active layer ACT overlaps the second gate electrode GE2, and may be in contact with the second channel region CH2 under the second gate electrode GE2.

The gate electrodes GE of the transistor elements TFT may include at least one metal selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W) and copper (Cu), but are not limited thereto. In an alternative embodiment, for example, the gate electrodes GE may include a metal and/or a conductive material other than the materials mentioned above.

The interlayer insulating layer ILD may be disposed on one surface of the base layer BSL including the transistor elements TFT, wherein other layers, in particular the insulating layer GI, may be placed between the base layer BSL and the insulating layer ILD.

Conductive patterns (for example, bridge patterns) including the connection electrode CNE and/or lines may be disposed on the interlayer insulating layer ILD. In an embodiment, where at least one transistor element TFT includes a separate source electrode and/or drain electrode, this source electrode and/or drain electrode may be disposed on the interlayer insulating layer ILD.

The passivation layer PSV may be disposed on one surface of the base layer BSL including the interlayer insulating layer ILD and the connection electrode CNE. In an embodiment, the passivation layer PSV may be a planarization layer that planarizes the surface of the panel circuit layer PCL. For example, the passivation layer PSV may include at least an organic insulating layer, and may substantially planarize the surface of the panel circuit layer PCL. In an embodiment, the passivation layer PSV may include an acrylic resin, an epoxy resin, an imide resin, an ester resin, or the like.

The light emitting element layer LEL may be disposed on the passivation layer PSV.

The light emitting element layer LEL may include the light emitting element ED of each pixel PX. For example, the light emitting element layer LEL may include at least one light emitting element ED disposed in the pixel area PXA (or emission area) of each pixel PX. In addition, the light emitting element layer LEL may further include a pixel defining layer PDL that defines the emission area of each pixel PX.

Each of the light emitting elements ED may include an anode electrode AE, a light emitting layer EML, and a cathode electrode CE. In an embodiment, the anode electrode AE, the light emitting layer EML, and the cathode electrode CE may be sequentially stacked on the panel circuit layer PCL. In an alternative embodiment, the cathode electrode CE may be first positioned on the panel circuit layer PCL, and the light emitting layer EML and the anode electrode AE may be sequentially stacked on the cathode electrode CE. Each light emitting element ED may penetrate the passivation layer PSV of the panel circuit layer PCL and the like to be connected to the pixel circuit PC of the corresponding pixel PX. For example, each light emitting element ED may be electrically connected to the first transistor TFT1 through the corresponding connection electrode CNE.

In an embodiment, the anode electrodes AE may be reflective electrodes, in which case the anode electrodes AE may be a metal layer containing a metal such as Ag, Mg, Al, Pt, Pd, Au, Ni, Nd, Ir, or Cr. In an alternative embodiment, the anode electrodes AE may further include a metal oxide layer stacked on the metal layer. In an embodiment, each of the anode electrodes AE may have a two-layer structure of ITO/Ag, Ag/ITO, ITO/Mg, or ITO/MgF, or a multilayer structure such as ITO/Ag/ITO. In an embodiment, the anode electrodes AE may be formed as individual patterns separated from each other.

The pixel defining layer PDL may be positioned on the anode electrodes AE. The pixel defining layer PDL may be provided with an opening exposing the anode electrode AE, corresponding to the emission area of the pixel PX.

In an embodiment, the pixel defining layer PDL may include an organic insulating material selected from acrylic resin, epoxy resin, phenolic resin, polyamide resin, polyimide resin, unsaturated polyester resin, polyphenylene ether resin, polyphenylenesulfide resin and benzocyclobutene (BCB). The material of the pixel defining layer PDL is not limited to those mentioned above, but may be changed according to embodiments.

The light emitting layer EML may be positioned on the anode electrode AE and the pixel defining layer PDL.

The light emitting layer EML may be disposed at least in a region corresponding to the opening of the pixel defining layer PDL. For example, the light emitting layer EML may be disposed on one surface of the first electrode AE that is exposed. The light emitting layer EML may have a multilayer thin film structure including at least a light generation layer. The light emitting layer EML may include: a hole injection layer for injecting holes; a hole transport layer that has high hole transportability and suppresses movement of electrons not combined in a light generation layer to increase the chance of recombination of the holes and the electrons; the light generation layer that emits light by the recombination of the injected electrons and holes; a hole blocking layer for suppressing movement of the holes that are not combined in the light generation layer; an electron transport layer for smoothly transporting the electrons to the light generation layer; and an electron injection layer for injecting the electrons.

In an embodiment, the light emitting layer EML (for example, the light generation layer) may be individually formed in the emission area of each pixel PX. In an alternative embodiment, the light emitting layer EML may have a shape of a continuous film in the display area DA, and may have a shape of a common film shared by the several pixels PX. In an embodiment where the EML has a shape of a common film, the light emitting elements ED of the adjacent pixels PX may emit light of a same color, and the color of the light emitted from the pixels PX may be controlled and/or converted by providing a color filter layer and/or a wavelength conversion layer on top of the light emitting elements ED.

The cathode electrode CE may be positioned on the light emitting layer EML. In an embodiment, the cathode electrode CE may be a common film shared by the pixels PX, but is not limited thereto.

In an embodiment, the cathode electrode CE may have a semi-transmissive or transmissive property. In an embodiment where the cathode electrode CE has a semi-transmissive property, the cathode electrode CE may include Ag, Mg, Cu, Al, Pt, Pd, Au, Ni, Nd, Ir, Cr, Li, Ca, LiF/Ca, LiF/Al, Mo, Ti or a compound or mixture thereof, such as a mixture of Ag and Mg. In an embodiment, where the cathode electrode CE has a thickness of tens to hundreds of angstroms, the cathode electrode CE may have a semi-transmissive property.

In case that the cathode electrode CE has a transmissive property, the cathode electrode CE may include a transparent conductive oxide (TCO). For example, the cathode electrode CE may include tungsten oxide (WxOy), titanium oxide (TiO₂), indium tin oxide (ITO), indium zinc oxide (IZO), zinc oxide (ZnO), indium tin zinc oxide (ITZO), magnesium oxide (MgO) or the like.

The encapsulation layer ENC may be disposed or provided on the light emitting element layer LEL. The encapsulation layer ENC may be formed at least in the display area DA. For example, the encapsulation layer ENC may be formed in the display area DA and the non-display area NDA. In an embodiment, the encapsulation layer ENC may directly cover the cathode electrode CE. In an alternative embodiment, a capping layer (not illustrated) covering the cathode electrode CE may be provided between the encapsulation layer ENC and the cathode electrode CE, and the encapsulation layer ENC may directly cover the capping layer.

In an embodiment, the encapsulation layer ENC may include a first encapsulation layer ENC1, a second encapsulation layer ENC2, and a third encapsulation layer ENC3 sequentially stacked on the cathode electrode CE. In an embodiment, each of the first encapsulation layer ENC1 and the third encapsulation layer ENC3 may be an inorganic layer including or formed of silicon nitride, aluminum nitride, zirconium nitride, titanium nitride, hafnium nitride, tantalum nitride, silicon oxide, aluminum oxide, titanium oxide, tin oxide, cerium oxide, silicon oxynitride (SiON), lithium fluoride or the like. In an embodiment, the second encapsulation layer ENC2 may be an organic layer including or formed of acrylic resin, methacrylic resin, polyisoprene, vinyl resin, epoxy resin, urethane resin, cellulose resin, perylene resin or the like. The structure of the encapsulation layer ENC and the material constituting it may be changed according to embodiments.

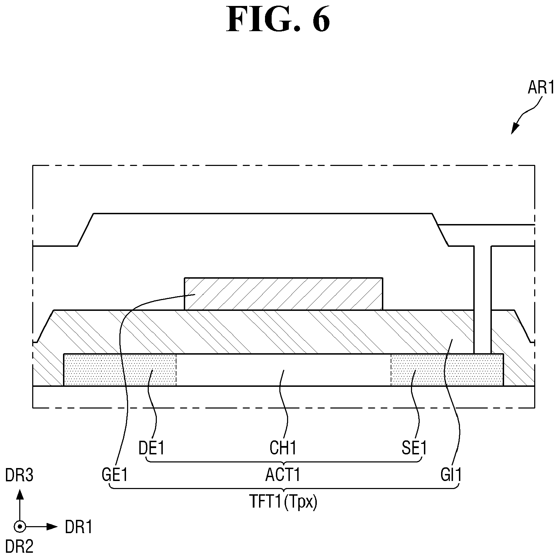

FIG. 6 is an enlarged cross-sectional view of a first area AR1 where the first transistor TFT1 is disposed according to an embodiment.

Referring to FIG. 6 in addition to FIGS. 1 to 5, the first gate insulating layer GI1 may entirely cover (or overlap in the third direction DR3) the first active layer ACT1 including the first channel region CH1, the first source region SE1, and the first drain region DE1, in an unetched state. The first gate electrode GE1 may not overlap the first source region SE1 and the first drain region DE1. For example, the boundary of the first channel region CH1 and the first source region SE1 may be located at an edge of a region where the first gate electrode GE1 overlaps the first active layer ACT1, or may be located outside the region where the first gate electrode GE1 overlaps the first active layer ACT1. Similarly, the boundary of the first channel region CH1 and the first drain region DE1 may be located at an edge of a region where the first gate electrode GE1 overlaps the first active layer ACT1, or may be located outside the region where the first gate electrode GE1 overlaps the first active layer ACT1. The first gate electrode GE1 may have a smaller length than the first channel region CH1.

In an embodiment shown in FIGS. 5 and 6, where the first transistor TFT1 has a structure in which the first gate electrode GE1 does not overlap the first source region SE1 and the first drain region DE1, a parasitic capacitance (e.g., a parasitic capacitance that may be formed between the first gate electrode GE1 and the first source region SE1 and the first drain region DE1) may be effectively prevented from occurring in the first transistor TFT1, or the magnitude of the parasitic capacitance may be substantially decreased or minimized. Accordingly, the parasitic capacitance may be effectively prevented from affecting the operation of the first transistor TFT1, and the operation characteristics and performance of the first transistor TFT1 may be improved. in an embodiment, for example, where the first transistor TFT1 is the pixel transistor Tpx, a change in the luminance of the pixel PX due to the parasitic capacitive coupling may be effectively prevented or minimized. In an embodiment, for example, where the first transistor TFT1 is the first pixel transistor T1, a change in the driving current Id due to the parasitic capacitance may be effectively prevented or decreased. Accordingly, in such embodiments, the display device 100 may display an image of uniform quality.

In such embodiments, the first source region SE1 and the first drain region DE1 may become conductive so that an appropriate level of carrier mobility (e.g., electron mobility) may be secured within a range in which the pixel PX may operate stably. For example, the pixel PX may be driven smoothly by forming the first transistor TFT1 to exhibit an operation characteristic corresponding to a predetermined response time range.

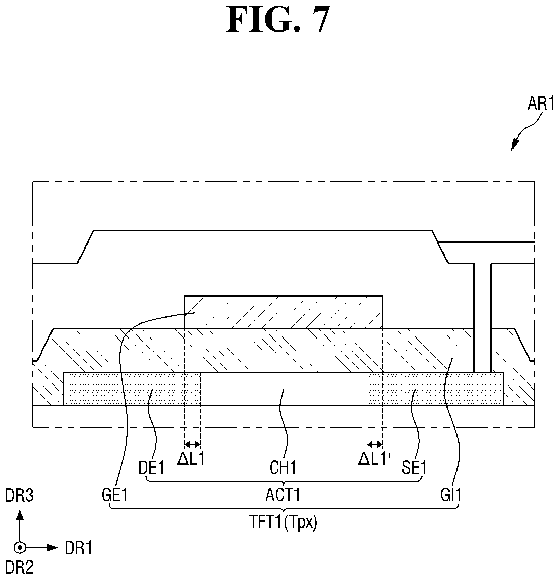

FIG. 7 is an enlarged cross-sectional view of the first area AR1 where the first transistor TFT1 is disposed according to an embodiment. The embodiment of FIG. 7 is substantially the same as the embodiment of FIG. 6 except that the first gate electrode GE1 partially overlaps the first source region SE1 and the first drain region DE1.

Referring to FIG. 7 in addition to FIGS. 1 to 6, the first gate insulating layer GI1 may entirely cover the first active layer ACT1 including the first channel region CH1, the first source region SE1, and the first drain region DE1, in an unetched state. Further, the first gate electrode GE1 may overlap a part of the first source region SE1 (e.g., a part adjacent to the first channel region CH1) and a part of the first drain region DE1 (e.g., a part adjacent to the first channel region CH1). The first gate electrode GE1 may have a greater length than the first channel region CH1.

In an embodiment, the first gate electrode GE1 may overlap the first source region SE1 and the first drain region DE1 by a part corresponding to a first length in a longitudinal direction of the first channel region CH1 (e.g., a direction in which carriers move between the first source region SE1 and the first drain region DE1, such as the first direction DRIin which the first channel region CH1 extends). In this case, the first length may correspond to a sum of a length △L1 of an area where the first gate electrode GE1 overlaps the first drain region DE1 and a length △L1' of an area where the first gate electrode GE1 overlaps the first source region SE1. In an embodiment, the length △L1 of the area where the first gate electrode GE1 overlaps the first drain region DE1 may be substantially the same as or similar to the length △L1' of the area where the first gate electrode GE1 overlaps the first source region SE1, but the invention is not limited thereto. As the first source region SE1 and the first drain region DE1 respectively extend into the area overlapping the first gate electrode GE1, the length of the first channel region CH1 may become relatively smaller.

From the perspective of the overlap area, the first gate electrode GE1 may overlap the first source region SE1 and the first drain region DE1 by a part corresponding to a first ratio among parts overlapping the first active layer ACT1. In an embodiment, the first ratio may correspond to (e.g., be proportional to) the first length, but is not limited thereto.

In an embodiment, as shown in FIG. 7, the first transistor TFT1 may have a structure in which the first gate electrode GE1 overlaps the part of the first source region SE1 and the part of the first drain region DE1 are formed in the process of making the first source region SE1 and the first drain region DE1 conductive so that the first transistor TFT1 has a higher carrier mobility. For example, compared to the first transistor TFT1 according to the embodiment of FIG. 6, although the first transistor TFT1 according to the embodiment of FIG. 7 may have a greater parasitic capacity that may occur between the first gate insulating layer GI1 and the first source region SE1 and the first drain region DE1, the first transistor TFT1 according to the embodiment of FIG. 7 may have a higher carrier mobility.

In an embodiment, the first source region SE1 and the first drain region DE1 may be formed so that the first transistor TFT1 has a higher carrier mobility (e.g., a higher carrier mobility than that of the first transistor TFT1 according to the embodiment of FIG. 6) while maintaining the parasitic capacity formed in the first transistor TFT1 below an appropriate level that does not significantly affect the operation characteristics of the first transistor TFT1. Accordingly, the operation characteristics (e.g., response time and/or switching characteristics) may be improved while securing the reliability of the first transistor TFT1.

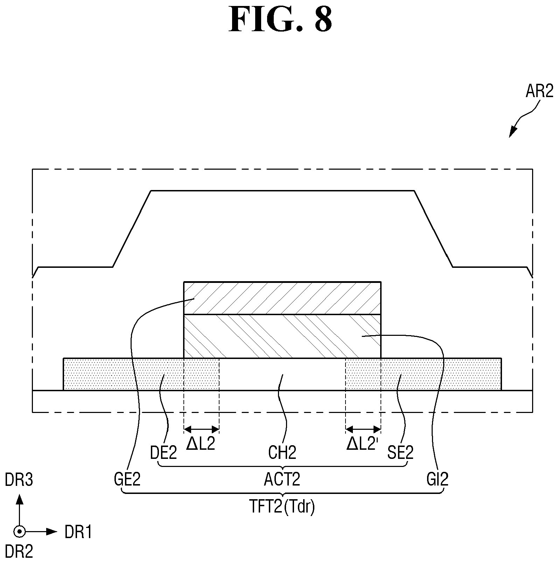

FIG. 8 is an enlarged cross-sectional view of a second area AR2 where the second transistor TFT2 is disposed according to an embodiment.

Referring to FIG. 8 in addition to FIGS. 1 to 7, the second gate insulating layer GI2 may be locally disposed on only a part of the second active layer ACT2 in an etched form. For example, the second gate insulating layer GI2 may be disposed only on a part of the second active layer ACT2 that overlaps the second gate electrode GE2.

In an embodiment, the second gate insulating layer GI2 may overlap the second channel region CH2, a part of the second source region SE2, and a part of the second drain region DE2. For example, the second gate insulating layer GI2 may be disposed on the second channel region CH2, a part of the second source region SE2 (e.g., a part adjacent to the second channel region CH2), and a part of the second drain region DE2 (e.g., a part adjacent to the second channel region CH2) while exposing the remaining parts of the second source region SE2 and the second drain region DE2 except for the parts overlapping the second gate electrode GE2.

In an embodiment, the second gate electrode GE2 may overlap the second source region SE2 and the second drain region DE2 by a part corresponding to a second length in a longitudinal direction of the second channel region CH2 (e.g., a direction in which carriers move between the second source region SE2 and the second drain region DE2, such as the first direction DR1 in which the second channel region CH2 extends). In this case, the second length may correspond to a sum of a length ΔL2 of an area where the second gate electrode GE2 overlaps the second drain region DE2 and a length △L2' of an area where the second gate electrode GE2 overlaps the second source region SE2. In an embodiment, the length △L2 of the area where the second gate electrode GE2 overlaps the second drain region DE2 may be substantially the same as or similar to the length △L2' of the area where the second gate electrode GE2 overlaps the second source region SE2, but the invention is not limited thereto. As the second source region SE2 and the second drain region DE2 extend into the area overlapping the second gate electrode GE2, the length of the second channel region CH2 may become relatively smaller.

From the perspective of the overlap area, the second gate electrode GE2 may overlap the second source region SE2 and the second drain region DE2 by a part corresponding to a second ratio among parts overlapping the second active layer ACT2. In an embodiment, the second ratio may correspond to (e.g., be proportional to) the second length, but the invention is not limited thereto.

In an embodiment, as shown in FIG. 8, the second transistor TFT2 may have the structure in which the second gate electrode GE2 overlaps the part of the second source region SE2 and the part of the second drain region DE2 are formed in the process of making the second source region SE2 and the second drain region DE2 conductive so that the second transistor TFT2 has a higher carrier mobility. In an embodiment, the length (e.g., the second length), size, and/or ratio (e.g., the second ratio) of the area where the second gate electrode GE2 overlaps the second source region SE2 and the second drain region DE2 may be greater than the length (e.g., the first length), size, and/or ratio (e.g., the first ratio) of the area where the first gate electrode GE1 overlaps the first source region SE1 and the first drain region DE1 in the embodiment of FIG. 7. Further, the second transistor TFT2 may be formed to have a higher carrier mobility than the first transistor TFT1.

For example, compared to the first transistor TFT1 according to the embodiment of FIG. 6 or the embodiment of FIG. 7, although the second transistor TFT2 according to the embodiment of FIG. 8 may have a greater parasitic capacity (parasitic capacity occurring between the second gate insulating layer GI2 and the second source region SE2 and the second drain region DE2), the second transistor TFT2 may have a higher carrier mobility. In an embodiment, the first transistor TFT1 and the second transistor TFT2 may be N-type transistors (e.g., N-type oxide transistors), and the electron mobility of the second transistor TFT2 may be higher than the electron mobility of the first transistor TFT1.

In an embodiment, the second transistor TFT2 may be a driving transistor Tdr. The driving transistor Tdr may be an element that may be operated normally even if a certain amount of parasitic capacitance (e.g., a greater parasitic capacitance compared to the pixel transistor Tpx) occurs and be desired to have higher switching characteristics. Therefore, when the second transistor TFT2 is formed to have a higher carrier mobility by applying the structure according to the embodiment of FIG. 8, the output characteristics of the driving circuit 121 may be improved. For example, the driving transistors Tdr (e.g., the fifth to eighth driving transistors M5 to M8), which are included in the output unit 540 of at least the stage ST, may be formed to have a structure in which the second gate insulating layer GI2 is etched and to have a high carrier mobility according to the embodiment of FIG. 8. Accordingly, the output characteristics of the driving circuit 121 may be improved.

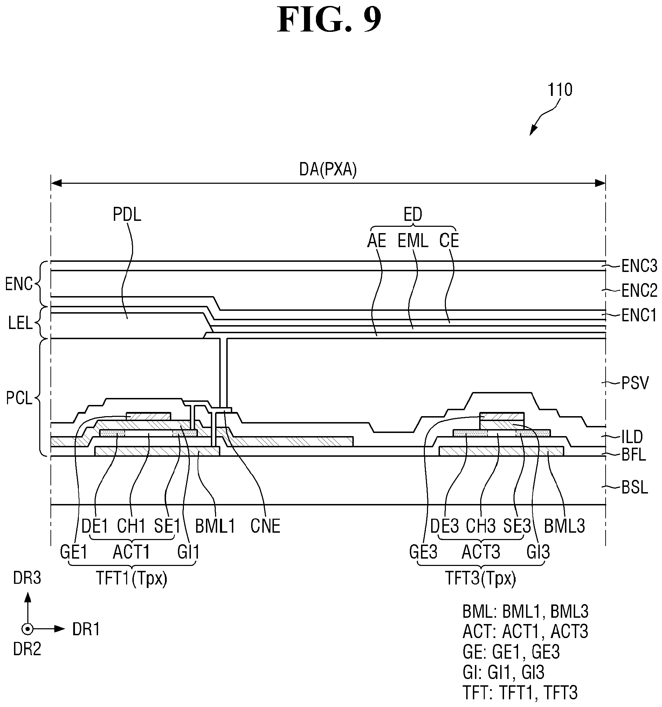

FIG. 9 is a cross-sectional view illustrating the display panel 110 according to an embodiment. For example, FIG. 9 shows a part of the display area DA of the display panel 110. FIG. 9 illustrates two pixel transistors Tpx having different structures from each other (hereinafter, referred to as "first transistor TFT1" and "third transistor TFT3", respectively) as an example of circuit elements that may be provided or arranged in the panel circuit layer PCL of the display area DA.

Referring to FIG. 9 in addition to FIGS. 1 to 8, the display panel 110 may further include the third transistor TFT3 located in each pixel area PXA of the display area DA. In an embodiment, the third transistor TFT3 may be an oxide transistor including an oxide semiconductor. For example, a third active layer ACT3 of the third transistor TFT3 may be formed using a same oxide semiconductor as the first active layer ACT1 of the first transistor TFT1 and the second active layer ACT2 of the second transistor TFT2. In an embodiment, a third lower metal layer BML3 may be disposed or formed under the third transistor TFT3.

In an embodiment, the pixel PX may include the pixel transistors Tpx having different structures and/or different carrier mobilities from each other. For example, the first transistor TFT1 of the pixel PX may have a structure in which the first gate insulating layer GI1 is not etched as in the embodiment of FIG. 6 or the embodiment of FIG. 7. The third transistor TFT3 of the pixel PX may have a structure in which a third gate insulating layer GI3 is etched substantially similar to or identical to that of the second transistor TFT2 of FIG. 8. Further, compared to the first source region SE1 and the first drain region DE1 of the first transistor TFT1, a third source region SE3 and a third drain region DE3 of the third transistor TFT3 may have a greater length, a greater area, and/or a greater ratio to the third active layer ACT3. Further, the third transistor TFT3 may be formed to have a higher carrier mobility than the first transistor TFT1.

In an embodiment, each pixel transistor Tpx may be formed in a same structure as the first transistor TFT1 or in a same structure as the third transistor TFT3 in consideration of operation characteristics or reliability desired for each pixel transistor Tpx. For example, a pixel transistor Tpx having a high risk of luminance fluctuation due to a parasitic capacitance (e.g., the first pixel transistor T1 of FIG. 2) may be formed in a structure in which a parasitic capacitance can be effectively prevented or minimized such as the first transistor TFT1. A pixel transistor Tpx requiring a high speed switching operation (e.g., the second pixel transistor T2 of FIG. 2) may be formed in a structure with high carrier mobility such as the third transistor TFT3.

The third transistor TFT3 may include the third active layer ACT3, the third gate insulating layer GI3, and the third gate electrode GE3.

The third active layer ACT3 may be disposed on the buffer layer BFL. For example, the third active layer ACT3 may be disposed in (or directly on) a same layer as the first active layer ACT1, and may be formed simultaneously therewith.

The third active layer ACT3 may include the third channel region CH3, and the third source region SE3 and the third drain region DE3 that are spaced apart from each other while interposing the third channel region CH3 therebetween. For example, the third source region SE3 and the third drain region DE3 may be located on either side of the third channel region CH3. The third channel region CH3 may be a region that maintains semiconductor characteristics without becoming conductive, while the third source region SE3 and the third drain region DE3 may be regions that have become conductive.

In an embodiment, the third source region SE3 may function as a source electrode of the third transistor TFT3, and the third drain region DE3 may function as a drain electrode of the third transistor TFT3. In an alternative embodiment, the third transistor TFT3 may further include a separate source electrode connected to the third source region SE3 and/or a separate drain electrode connected to the third drain region DE3 .

The third gate insulating layer GI3 may be disposed on the third active layer ACT3. In an embodiment, the third gate insulating layer GI3 may have an etched form to expose at least a part of each of the third source region SE3 and the third drain region DE3. For example, the third gate insulating layer GI3 may be disposed only on a part of the third active layer ACT3 including the third channel region CH3, and may expose the third source region SE3 and the third drain region DE3. In an embodiment, the third gate insulating layer GI3 may be locally disposed on the active layer ACT included in each of the transistor elements TFT that are at least some of the transistor elements TFT located in the display area DA (e.g., the pixel transistors Tpx including the first transistor TFT1 and the third transistor TFT3).

In case that the third gate insulating layer GI3 has an etched form to expose the third source region SE3 and the third drain region DE3, the length, width, and/or area of the third source region SE3 and the third drain region DE3 may be extended and the conductivity thereof may be increased in the process of forming the third transistor TFT3 and/or the subsequent process. Accordingly, the carrier mobility (e.g., electron mobility) of the third transistor TFT3 may be increased, and the operation characteristics (e.g., operation speed and/or switching characteristics) thereof may be improved. Accordingly, the operation of the pixel PX may be stabilized and the response time may be decreased.

The third gate electrode GE3 may be disposed on the third gate insulating layer GI3. The third gate electrode GE3 may overlap a part of the third active layer ACT3. For example, the third gate electrode GE3 may be disposed on the third channel region CH3 to overlap the third channel region CH3. In an embodiment, the third gate electrode GE3 may partially overlap the third source region SE3 and the third drain region DE3. For example, the third source region SE3 and the third drain region DE3 may extend into the area where the third active layer ACT3 overlaps the third gate electrode GE3, and may be in contact with the third channel region CH3 under the third gate electrode GE3.

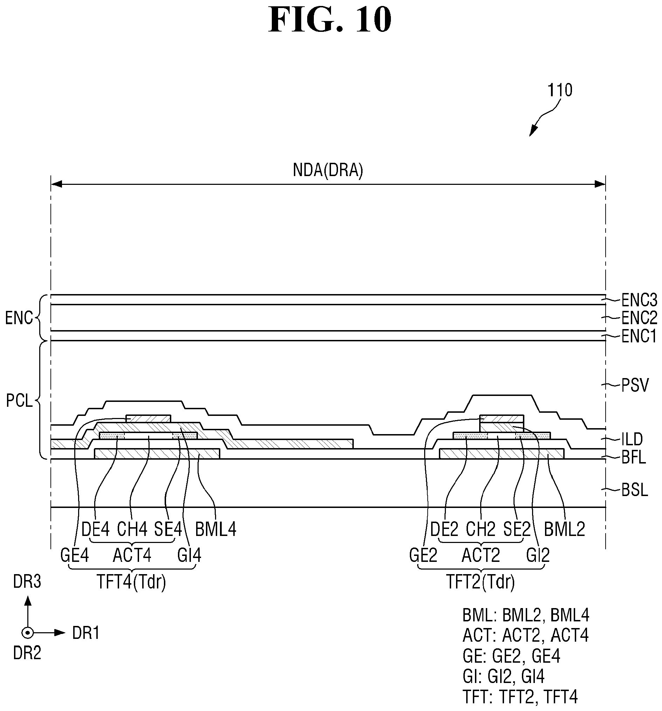

FIG. 10 is a cross-sectional view illustrating the display panel 110 according to an embodiment. Particularly, FIG. 10 shows a part of the non-display area NDA of the display panel 110. FIG. 10 illustrates two driving transistors Tdr having different structures from each other (hereinafter referred to as "second transistor TFT2" and "fourth transistor TFT4," respectively) as an example of circuit elements that may be provided or arranged in the panel circuit layer PCL of the non-display area NDA.

Referring to FIG. 10 in addition to FIGS. 1 to 8, the display panel 110 may further include the fourth transistor TFT4 located in the driving circuit area DRA of the non-display area NDA. In an embodiment, the fourth transistor TFT4 may be an oxide transistor including an oxide semiconductor. For example, the fourth active layer ACT4 of the fourth transistor TFT4 may be formed using a same oxide semiconductor as the second active layer ACT2 of the second transistor TFT2. In an embodiment, a fourth lower metal layer BMI,4 may be disposed or formed under the fourth transistor TFT4.

In an embodiment, the driving circuit 121 may include the driving transistors Tdr having different structures and/or carrier mobilities. For example, the second transistor TFT2 of the driving circuit 121 may have a structure in which the second gate insulating layer GI2 is etched similarly to the embodiment of FIG. 8. The fourth transistor TFT4 of the driving circuit 121 may have a structure in which a fourth gate insulating layer GI4 is not etched substantially similar or identical to the first transistor TFT1 of FIG. 6 or 7. Further, compared to the second source region SE2 and the second drain region DE2 of the second transistor TFT2, the fourth source region SE4 and the fourth drain region DE4 of the fourth transistor TFT4 may be formed to have a smaller length, area, and/or ratio to the fourth active layer ACT4, and have a decreased parasitic capacitance that may occur between them and the fourth gate electrode GE4.

In an embodiment, each driving transistor Tdr may be formed in a same structure as the second transistor TFT2 or a same structure as the fourth transistor TFT4 in consideration of operation characteristics or reliability desired for each driving transistor Tdr. For example, the driving transistor Tdr that requires better switching characteristics and small response time (e.g., at least one of the driving transistors Tdr included in the output unit 540 of FIG. 4) may be formed in a same structure with high carrier mobility similarly to the second transistor TFT2. The remaining driving transistors Tdr may be formed in a same structure as the fourth transistor TFT4 to reduce the effect of parasitic capacitance.

The fourth transistor TFT4 may include the fourth active layer ACT4, the fourth gate insulating layer GI4, and the fourth gate electrode GE4.

The fourth active layer ACT4 may be disposed on the buffer layer BFL. For example, the fourth active layer ACT4 may be disposed in (or directly on) a same layer as the second active layer ACT2, and may be formed simultaneously therewith.

The fourth active layer ACT4 may include the fourth channel region CH4, and the fourth source region SE4 and the fourth drain region DE4 that are spaced apart from each other while interposing the fourth channel region CH4 therebetween. For example, the fourth source region SE4 and the fourth drain region DE4 may be located on either side of the fourth channel region CH4. The fourth channel region CH4 may be a region that maintains semiconductor characteristics without becoming conductive, while the fourth source region SE4 and the fourth drain region DE4 may be regions that have become conductive.

In an embodiment, the fourth source region SE4 may function as a source electrode of the fourth transistor TFT4, and the fourth drain region DE4 may function as a drain electrode of the fourth transistor TFT4. In an alternative embodiment, the fourth transistor TFT4 may further include a separate source electrode connected to the fourth source region SE4 and/or a separate drain electrode connected to the fourth drain region DE4.

The fourth gate insulating layer GI4 may be disposed on the fourth active layer ACT4. In an embodiment, the fourth gate insulating layer GI4 may be in an unetched state. For example, the fourth gate insulating layer GI4 may be formed to entirely cover the fourth active layer ACT4, except for a contact portion for electrical connections between components of the driving circuit 121 (e.g., a contact hole defined or formed in the fourth gate insulating layer GI4 for connecting the fourth transistor TFT4 to other circuit elements, wiring and/or the like). For example, the fourth gate insulating layer GI4 may be formed entirely on the fourth active layer ACT4 at least in the region where the fourth transistor TFT4 is formed to cover the fourth channel region CH4, the fourth source region SE4, and the fourth drain region DE4.

In case that the fourth gate insulating layer GI4 entirely covers the fourth active layer ACT4, a parasitic capacitance, which may be formed between the fourth gate electrode GE4 and the fourth source region SE4 and the fourth drain region DE4 may be effectively prevented, substantially decreased, or minimized. Accordingly, the parasitic capacitance may be effectively prevented from affecting the operation of the fourth transistor TFT4, and secure the reliability of the fourth transistor TFT4.

The fourth gate electrode GE4 may be disposed on the fourth gate insulating layer GI4. The fourth gate electrode GE4 may overlap a part of the fourth active layer ACT4. For example, the fourth gate electrode GE4 may be disposed on the fourth channel region CH4 to overlap the fourth channel region CH4. The fourth gate electrode GE4 may partially overlap the fourth source region SE4 and the fourth drain region DE4 or may not overlap the fourth source region SE4 and the fourth drain region DE4. For example, the fourth gate electrode GE4 may be disposed only on a part of the fourth active layer ACT4 including the fourth channel region CH4.

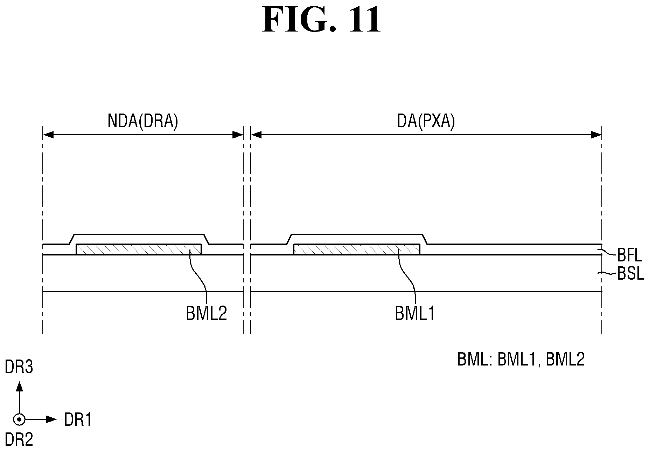

FIGS. 11 to 16 are cross-sectional views illustrating a method for manufacturing a display device 100 according to an embodiment. Particularly, FIGS. 11 to 16 sequentially illustrate processes of forming the display circuit layer PCL according to an embodiment among processes of manufacturing the display panel 110 of FIG. 5.

Referring to FIG. 11 in addition to FIGS. 1 to 10, the base layer BSL (also referred to as a "base member") where the display area DA and the non-display area NDA are defined is prepared, and the lower metal layers BML are formed on the base layer BSL in the display area DA and non-display area NDA. For example, the first lower metal layer BMI,1 may be formed in each pixel area PXA of the display area DA, and the second lower metal layer BML2 may be formed in the driving circuit area DRA of the non-display area NDA. Then, the buffer layer BFL may be formed on the base layer BSL to cover the lower metal layers BML.

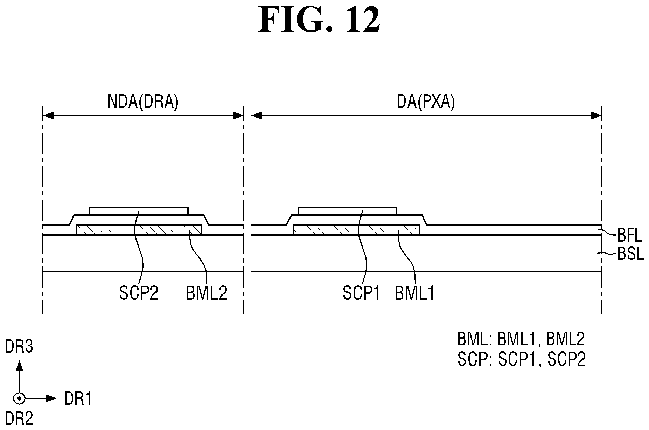

Referring to FIG. 12 in addition to FIGS. 1 to 11, semiconductor patterns SCP are formed on the base layer BSL including the lower metal layers BML and the buffer layer BFL to form the active layers ACT of the transistor elements TFT. For example, a first semiconductor pattern SCP1 may be formed in each pixel area PXA of the display area DA, and a second semiconductor pattern SCP2 may be formed in the driving circuit area DRA of the non-display area NDA.

In an embodiment, the semiconductor patterns SCP may be formed using a same oxide semiconductor. For example, the semiconductor patterns SCP for forming the active layers ACT of the pixel transistors Tpx and the driving transistors Tdr may be simultaneously formed in (or directly on) a same layer using a same native oxide semiconductor. Accordingly, the manufacturing cost of the display panel 110 may be reduced and the manufacturing efficiency thereof may be increased. The oxide semiconductor used to form the semiconductor patterns SCP may be at least one selected from the above-described materials, but is not limited thereto.

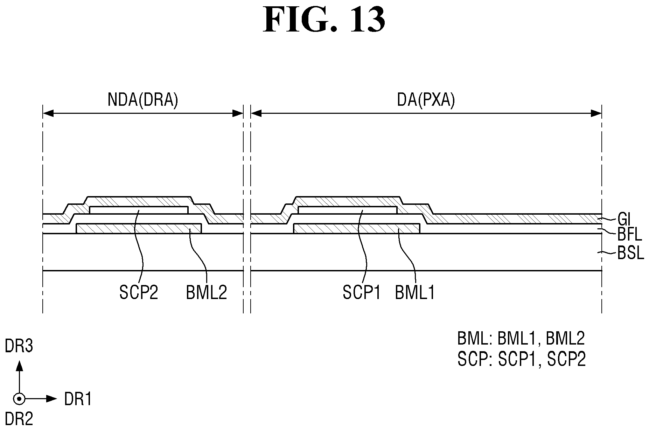

Referring to FIG. 13 in addition to FIGS. 1 to 12, the gate insulating layer GI (or a first insulating layer) is formed on the base layer BSL on which the semiconductor patterns SCP is formed to cover the semiconductor patterns SCP. In an embodiment, the gate insulating layer GI may be formed entirely on the display area DA and the non-display area NDA where the semiconductor patterns SCP have been formed. In an embodiment, the gate insulating layer GI may be formed using silicon nitride (SiNₓ), silicon oxide (SiOₓ), or silicon oxynitride (SiOₓN_{y}), but is not limited thereto.

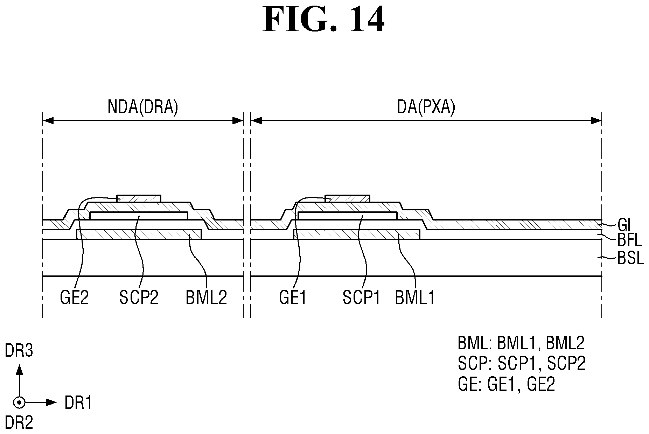

Referring to FIG. 14 in addition to FIGS. 1 to 13, the gate electrodes GE may be formed on the gate insulating layer GI to overlap the semiconductor patterns SCP, respectively. For example, the first gate electrode GE1 may be formed on the gate insulating layer GI covering the first semiconductor pattern SCP1 to overlap a center part of the first semiconductor pattern SCP1. Similarly, the second gate electrode GE2 may be formed on the gate insulating layer GI covering the second semiconductor pattern SCP2 to overlap a center part of the second semiconductor pattern SCP2.

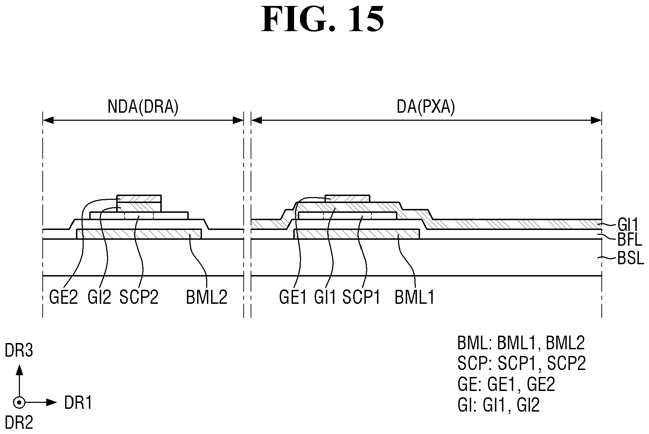

Referring to FIG. 15 in addition to FIGS. 1 to 14, the first gate insulating layer GI1 and the second gate insulating layer GI2 may be formed by selectively and/or differentially etching the gate insulating layer GI by each area or in each portion. For example, the gate insulating layer GI is not etched in the display area DA, or the gate insulating layer GI is not etched at least in the area where the first semiconductor pattern SCP1 is formed and the vicinity thereof so that the first gate insulating layer GI1 may be formed to entirely cover the first semiconductor pattern SCP1. In the non-display area NDA, the gate insulating layer GI is etched at least in the area where the second semiconductor pattern SCP2 is formed and the vicinity thereof so that the second gate insulating layer GI2 may be formed to partially expose the second semiconductor pattern SCP2. For example, by etching the gate insulating layer GI using the second gate electrode GE2 as a mask in the non-display area NDA, the second gate insulating layer GI2 may be formed to expose a part of the second semiconductor pattern SCP2, which does not overlap the second gate electrode GE2.

In an embodiment, the pixel transistors Tpx may all be formed in a structure in which the gate insulating layer GI is not etched similarly to the first transistor TFT1. In such an embodiment, the driving transistors Tdr may all be formed in a structure in which the gate insulating layer GI is etched similarly to the second transistor TFT2. In this case, in the display area DA, the gate insulating layer GI (e.g., the first gate insulating layer GI1) is not etched so that the gate insulating layer GI entirely covers the semiconductor patterns SCP. The gate insulating layer GI is etched only in the non-display area NDA so that the second gate insulating layer GI2 may be formed to have an individual pattern.

In an alternative embodiment, the gate insulating layer GI is selectively etched by each area or each portion also in the display area DA, so that some of the pixel transistors Tpx may be formed in a structure in which the gate insulating layer GI is not etched, and the rest of the pixel transistors Tpx may be formed in a structure in which the gate insulating layer GI is etched. In such an embodiment, in the non-display area NDA, by selectively etching the gate insulating layer GI by each area or each portion, some of the driving transistors Tdr may be formed in a structure in which the gate insulating layer GI is not etched, and the rest of the drive transistors Tdr may be formed in a structure in which the gate insulating layer GI is etched.

In the process of etching the gate insulating layer GI to form the second gate insulating layer GI2, the characteristics of the second semiconductor pattern SCP2 may be changed so that the second semiconductor pattern SCP2 has different characteristics for each part. For example, mainly at a part that does not overlap the second gate electrode GE2, an oxide bond may be broken to release oxygen, and oxygen vacancy (or, oxygen deficiency) may occur in the oxide semiconductor constituting the second semiconductor pattern SCP2 by an etching gas or the like. Accordingly, the second semiconductor pattern SCP2 may be divided into a plurality of regions having different characteristics from each other. In an embodiment, the oxygen vacancy may occur mainly in a part of the second semiconductor pattern SCP2 that does not overlap the second gate electrode GE2, and may increase to a part of the region that overlaps the second gate electrode GE2.

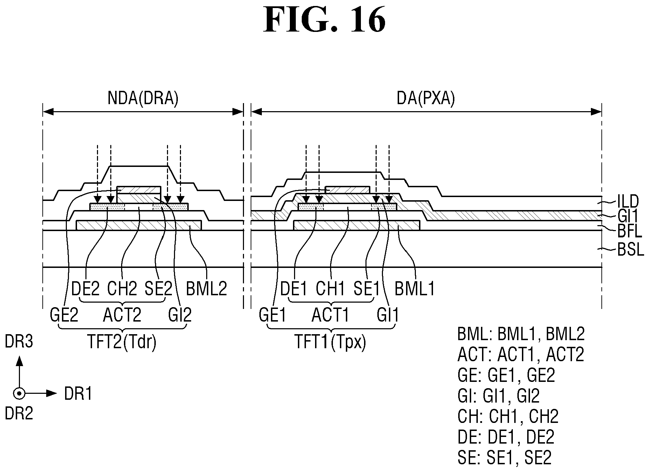

Referring to FIG. 16 in addition to FIGS. 1 to 15, the interlayer insulating layer ILD is formed to cover the semiconductor patterns SCP, the gate insulating layer GI, and the gate electrodes GE. For example, the interlayer insulating layer ILD may be formed entirely in the display area DA and the non-display area NDA to cover the first semiconductor pattern SCP1, the second semiconductor pattern SCP2, the first gate insulating layer GI1, the second gate insulating layer GI2, the first gate electrode GE1, and the second gate electrode GE2.

In the process of forming the interlayer insulating layer ILD, hydrogen may be introduced into the semiconductor patterns SCP. The hydrogen introduced into the semiconductor patterns SCP may combine with oxygen vacancies present in the semiconductor patterns SCP. FIG. 16 illustrates the introduction of hydrogen into certain portions of the semiconductor patterns SCP (e.g., the source regions SE and the drain regions DE) as dotted arrows. In an embodiment, a heat treatment process (e.g., annealing) may further be performed on the semiconductor patterns SCP before or after the formation of the interlayer insulating layer ILD. Hydrogen may be introduced into the semiconductor patterns SCP even in the heat treatment process.

Accordingly, as hydrogen is introduced into the semiconductor patterns SCP, some of the semiconductor patterns SCP mainly in the part containing a plurality of oxygen vacancies become conductive (e.g., N-type conductive) so that the active layers ACT may be formed. For example, the first semiconductor pattern SCP1 may be formed as the first active layer ACT1 including the first channel region CH1, the first source region SE1, and the first drain region DE1. The second semiconductor pattern SCP2 may be formed as the second active layer ACT2 including the second channel region CH2, the second source region SE2, and the second drain region DE2. The regions that have not become conductive in the semiconductor patterns SCP may form the channel regions CH.

In an embodiment, the second source region SE2 and the second drain region DE2 of the second semiconductor pattern SCP2 may be regions formed to include a greater number of oxygen vacancies and have a larger area during the etching process of the gate insulating layer GI, and may be formed to have a higher conductivity during the conductive treatment step. For example, the second source region SE2 and the second drain region DE2 of the second semiconductor pattern SCP2 may be regions that have become conductive with decreased oxygen content and/or increased hydrogen content compared to when the second semiconductor pattern SCP2 was initially formed.

In such an embodiment, the first source region SE1 and the first drain region DE1 of the first semiconductor pattern SCP1 may become conductive as hydrogen combines with oxygen vacancies that have been maintained mainly from the formation step of the semiconductor pattern SCP and are fewer than those of the second semiconductor pattern SCP2, and the parts not overlapping the first gate electrode GE1 may become conductive. Accordingly, the first source region SE1 and the first drain region DE1 may not overlap the first gate electrode GE1.

Through the above-described process, the transistor elements TFT including the first transistor TFT1 and the second transistor TFT2 (e.g., the pixel transistor Tpx and the driving transistor Tdr) may be formed. Then, the passivation layer PSV, the light emitting element layer LEL, and the encapsulation layer ENC may be formed on the interlayer insulating layer ILD, thereby manufacturing the display panel 110 of FIG. 5.

In an embodiment, the third transistor TFT3 of FIG. 9 may be formed in a substantially similar or identical manner to the second transistor TFT2. In an embodiment, the fourth transistor TFT4 of FIG. 10 may be formed in a substantially similar or identical manner to the first transistor TFT1.

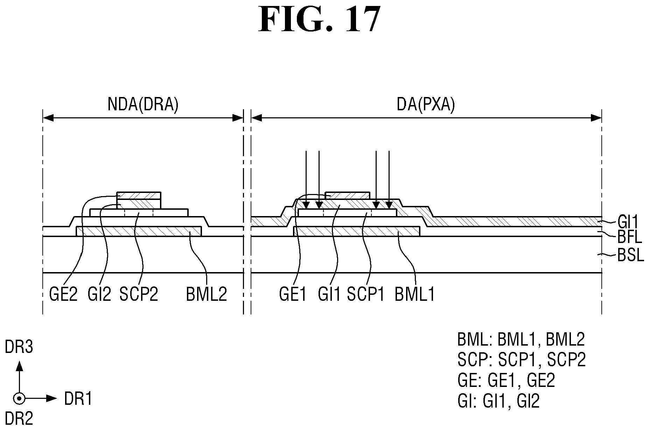

FIG. 17 is a cross-sectional view illustrating a method for manufacturing a display device 100 according to an embodiment. FIG. 17 illustrates a process in relation with the first transistor TFT1 that may be performed additionally according to an embodiment. The process may be performed after the formation of the gate electrodes GE. For example, the process of FIG. 17 may be performed before or after etching the gate insulating layer GI.

Referring to FIG. 17 in addition to FIGS. 1 to 16, prior to the formation of the interlayer insulating layer ILD, a process may be performed to dope impurities into the semiconductor patterns SCP (e.g., the first semiconductor pattern SCP1) for forming the active layer ACT of at least some transistor elements TFT including the transistor elements TFT (e.g., the first transistor TFT1) in which the gate insulating layer GI is not etched. For example, impurities may be doped into a part of the first semiconductor pattern SCP1, which does not overlap the first gate electrode GE1, by using the first gate electrode GE1 as a mask. In FIG. 17, a solid arrow indicates that impurities are doped into a part of the first semiconductor pattern SCP1. For example, the impurity may be boron (B) or phosphorus (P), but the type of impurity is not limited thereto.

Oxygen vacancies may occur in a region of the semiconductor pattern SCP (e.g., the first semiconductor pattern SCP1) where the impurities are doped. Accordingly, the first semiconductor pattern SCP1 may be divided into a plurality of regions having different characteristics from each other. In an embodiment, the oxygen vacancy may occur mainly in a part of the first semiconductor pattern SCP1 that does not overlap the first gate electrode GE1, and may increase to a part of a region that overlaps the first gate electrode GE1.

Accordingly, compared to the first transistor TFT1 formed according to an embodiment in which the first semiconductor pattern SCP1 is not doped with impurities, the first transistor TFT1, which is formed by adding the impurity doping process, may have a higher carrier mobility, and the first source region SE1 and the first drain region DE1 thereof may have a greater length, width, area, and/or ratio. For example, the first transistor TFT1 according to the embodiment of FIG. 7 may be formed by doping impurities.

According to embodiments of the invention, as described above, the transistor elements TFT of the display panel 110, for example, the pixel transistors Tpx and the driving transistors Tdr, may be formed as oxide transistors including oxide semiconductor. For example, a same oxide semiconductor (e.g., the same native oxide semiconductor) may be used to form the active layers ACT of the transistor elements TFT. Accordingly, the manufacturing efficiency of the display device 100 may be improved and the manufacturing cost thereof may be reduced. In such embodiments, the performance of the display device 100 may be improved based on the high carrier mobility and low leakage current characteristics exhibited by the oxide transistors.

Furthermore, according to embodiments of the invention, different structures may be applied to the transistor elements TFT according to the operation characteristics and/or performance required for each transistor element TFT. For example, the gate insulating layer GI of the transistor element TFT may be selectively etched according to operation characteristics and/or performance desired of each transistor element TFT. Accordingly, it characteristics of the transistor element TFT such as parasitic capacitance and carrier mobility may be effectively optimized or controlled.

For example, the transistor element TFT, which is desired to have a decrease in the parasitic capacity for stable operation, may be formed as a transistor having a structure in which the gate insulating layer GI is not etched. For example, the pixel transistor Tpx, which is desired to have a decrease or minimization in the parasitic capacity to prevent or improve image smearing, may be formed in a structure in which the gate insulating layer GI is not etched, and thus the parasitic capacity may be prevented, decreased, or minimized. On the other hand, the transistor element TFT, which is desired to have high carrier mobility, may be formed in a structure in which the gate insulating layer GI is etched, and therefore the carrier mobility may be higher. For example, the driving transistor Tdr, which is desired to have high carrier mobility to improve the output characteristics of the driving circuit 121, may be formed as a transistor in which the gate insulating layer GI is etched, and thus the carrier mobility may be higher.

According to embodiments of the invention, as described above, the performance of both the pixel transistor Tpx and the driving transistor Tdr may be improved and/or optimized.

The invention should not be construed as being limited to the embodiments set forth herein. Rather, these embodiments are provided so that this invention will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (100) comprising:
a pixel (PX) comprising a first transistor (TFT1) located in a display area (DA); and
a driving circuit (121) comprising a second transistor (TFT2) located in a non-display area (NDA),
wherein the first transistor (TFT1) comprises:
a first active layer (ACT1) comprising a first channel region (CH1), and a first source region (SE1) and a first drain region (DE1) which are spaced apart from each other with the first channel region (CH1) interposed therebetween;
a first gate insulating layer (GI1) disposed on the first active layer (ACT1) and covering the first channel region (CH1), the first source region (SE1) and the first drain region (DE1); and
a first gate electrode (GE1) disposed on the first gate insulating layer (GI1) and overlapping the first channel region (CH1),
wherein the second transistor (TFT2) comprises:
a second active layer (ACT2) comprising a second channel region (CH2), and a second source region (SE2) and a second drain region (DE2) which are spaced apart from each other with the second channel region (CH2) interposed therebetween;
a second gate insulating layer (GI2) disposed on a part of the second active layer (ACT2) comprising the second channel region (CH2) and exposing the second source region (SE2) and the second drain region (DE2); and
a second gate electrode (GE2) disposed on the second gate insulating layer (GI2) and overlapping the second channel region (CH2).

2. The display device (100) of claim 1, wherein the first active layer (ACT1) and the second active layer (ACT2) includes a same oxide semiconductor.

3. The display device (100) of claim 1 or 2, wherein the first active layer (ACT 1) and the second active layer (ACT2) are disposed in a same layer as each other.

4. The display device (100) of at least one of claims 1 to 3, wherein the second gate electrode (GE2) overlaps a part of the second source region (SE2) and a part of the second drain region (DE2).

5. The display device (100) of at least one of claims 1 to 4, wherein the second gate insulating layer (GI2) exposes a remaining part of the second source region (SE2) and a remaining part of the second drain region (DE2) except for the part of the second source region (SE2) overlapping the second gate electrode (GE2) and the part of the second drain region (DE2) overlapping the second gate electrode (GE2).

6. The display device (100) of at least one of claims 1 to 4, wherein the first gate electrode (GE1) does not overlap the first source region (SE1) and the first drain region (DE1).

7. The display device (100) of at least one of claims 1 to 4, wherein the first gate electrode (GE1) overlaps a part of the first source region (SE1) and a part of the first drain region (DE1).

8. The display device (100) of claim 7, wherein
the first gate electrode (GE1) overlaps the first source region (SE1) and the first drain region (DE1) by a part having a first length in a longitudinal direction of the first channel region (CH1),
the second gate electrode (GE2) overlaps the second source region (SE2) and the second drain region (DE2) by a part having a second length in a longitudinal direction of the second channel region (CH2), and
the second length is greater than the first length.

9. The display device (100) of claim 7, wherein
the first gate electrode (GE1) overlaps the first source region (SE1) and the first drain region (DE1) by a part corresponding to a first ratio among parts overlapping the first active layer (ACT1),
the second gate electrode (GE2) overlaps the second source region (SE2) and the second drain region (DE2) by a part corresponding to a second ratio among parts overlapping the second active layer (ACT2), and
the second ratio is greater than the first ratio.

10. The display device (100) of at least one of claims 1 to 9, wherein
the first transistor (TFT1) and the second transistor (TFT2) are N-type oxide transistors, and
an electron mobility of the second transistor (TFT2) is higher than an electron mobility of the first transistor (TFT1).

11. The display device (100) of at least one of claims 1 to 10, wherein the pixel further comprises a third transistor (TFT3),
wherein the third transistor (TFT3) comprises:
a third active layer (ACT3) comprising a third channel region (CH3), and a third source region (SE3) and a third drain region (DE3) which are spaced apart from each other with the third channel region (CH3) interposed therebetween;
a third gate insulating layer (GI3) disposed on a part of the third active layer (ACT3) and exposing the third source region (SE3) and the third drain region (DE3), wherein the part of the third active layer (ACT3) comprises the third channel region (CH3); and
a third gate electrode (GE3) disposed on the third gate insulating layer (GI3) and overlapping the third channel region (CH3).

12. The display device (100) of at least one of claims 1 to 11, wherein the driving circuit (121) further comprises a fourth transistor (TFT4),
wherein the fourth transistor (TFT4) comprises:
a fourth active layer (ACT4) comprising a fourth channel region (CH4), and a fourth source region (SE4) and a fourth drain region (DE4) which are spaced apart from each other with the fourth channel region (CH4) interposed therebetween;
a fourth gate insulating layer (GI4) disposed on the fourth active layer (ACT4) and covering the fourth channel region (CH4), the fourth source region (SE4) and the fourth drain region (DE4); and
a fourth gate electrode (GE4) disposed on the fourth gate insulating layer (GI4) and overlapping the fourth channel region (CH4).

13. A method for manufacturing a display device (100), in particular a display device of at least one of claims 1 to 12, the method comprising:
preparing a base layer (BSL) in which a display area (DA) and a non-display area (NDA) are defined, and forming a first semiconductor pattern (SCP1) and a second semiconductor pattern (SCP2) on the base layer (BSL) in the display area (DA) and the non-display area (NDA), respectively;
forming a first insulating layer (GI) on the base layer (BSL) to cover the first semiconductor pattern (SCP1) and the second semiconductor pattern (SCP2);
forming a first gate electrode (GE1) overlapping a part of the first semiconductor pattern (SCP1) and a second gate electrode (GE2) overlapping a part of the second semiconductor pattern (SCP2), on the first insulating layer (GI);
maintaining the first insulating layer (GI) in an unetched state on the first semiconductor pattern (SCP1) in the display area (DA), and etching the first insulating layer (GI) to expose a remaining part of the second semiconductor pattern (SCP2) which does not overlap the second gate electrode (GE2) in the non-display area (NDA); and
forming a second insulating layer (ILD) covering the first semiconductor pattern (SCP1), the second semiconductor pattern (SCP2), the first insulating layer (GI), the first gate electrode (GE1), and the second gate electrode (GE2).

14. The method of claim 13, wherein in the forming the first semiconductor pattern (SCP1) and the second semiconductor pattern (SCP2), the first semiconductor pattern (SCP1) and the second semiconductor pattern (SCP2) are simultaneously formed using a same oxide semiconductor.

15. The method of claim 13 or 14, further comprising:
doping impurities into a remaining part of the first semiconductor pattern (SCP1), which does not overlap the first gate electrode (GE1), by using the first gate electrode (GE1) as a mask.
